(19) Europäisches Patentamt
European Patent Office
Office européen des brevets

(11) EP 4 668 017 A1

(12) EUROPEAN PATENT APPLICATION
published in accordance with Art. 153(4) EPC

(43) Date of publication:
**24.12.2025 Bulletin 2025/52**

(21) Application number: **24777539.8**

(22) Date of filing: **06.02.2024**

(51) International Patent Classification (IPC):
***G03F 7/004*** *(2006.01)*

(52) Cooperative Patent Classification (CPC):
**G02B 5/32; G03F 7/004; G03F 7/027; G03H 1/04**

(86) International application number:
**PCT/CN2024/076458**

(87) International publication number:
**WO 2024/198745 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.03.2023 CN 202310368492**

(71) Applicant: **Huawei Technologies Co., Ltd.**
**Shenzhen, Guangdong 518129 (CN)**

(72) Inventors:
- **PENG, Haiyan**
  **Wuhan, Hubei 430074 (CN)**
- **GUO, Hongxi**
  **Wuhan, Hubei 430074 (CN)**
- **XIE, Xiaolin**
  **Wuhan, Hubei 430074 (CN)**
- **ZHOU, Xingping**
  **Wuhan, Hubei 430074 (CN)**
- **YU, Hanchen**
  **Shenzhen, Guangdong 518129 (CN)**
- **LI, Zhe**
  **Shenzhen, Guangdong 518129 (CN)**
- **HUANG, Xin**
  **Shenzhen, Guangdong 518129 (CN)**
- **LI, Xin**
  **Shenzhen, Guangdong 518129 (CN)**

(74) Representative: **Thun, Clemens**
**Mitscherlich PartmbB**
**Patent- und Rechtsanwälte**
**Karlstraße 7**
**80333 München (DE)**

# (54) HOLOGRAPHIC PHOTOPOLYMERIZABLE MATERIAL, HOLOGRAPHIC PHOTOSENSITIVE FILM, HOLOGRAPHIC OPTICAL ELEMENT, AND DISPLAY DEVICE

(57) A holographic photopolymer material, a holographic photosensitive film, a holographic optical element, and a display device are provided. The holographic photopolymer material includes a polymer matrix, photopolymerizable monomers, and a photosensitizer. An index of refraction of the photopolymerizable monomer is greater than an index of refraction of the polymer matrix. A molecular structure of the polymer matrix includes a linear structure, and branch chains of the polymer matrix include activation groups; and/or the molecular structure of the polymer matrix includes a crosslinked structure. The polymer matrix whose molecular structure is the crosslinked structure has a high glass transition temperature, so that the holographic photopolymer material has good heat resistance. The holographic photopolymer material whose molecular structure is a linear structure includes the activation groups that may form a crosslinked structure, so that an optical element made from the holographic photopolymer material can have a crosslinked structure, that is, the optical element can have good heat resistance. The holographic photopolymer material has good heat resistance, or the optical element made from the holographic photopolymer material can have good heat resistance.

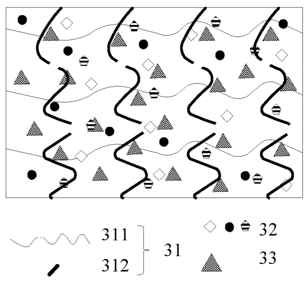


FIG. 3

EP 4 668 017 A1

## Description

This application claims priority to Chinese Patent Application No. 202310368492.9, filed with the China National Intellectual Property Administration on March 30, 2023 and entitled "HOLOGRAPHIC PHOTOPOLYMER MATERIAL, HOLOGRAPHIC PHOTOSENSITIVE FILM, HOLOGRAPHIC OPTICAL ELEMENT, AND DISPLAY DEVICE", which is incorporated herein by reference in its entirety.

## TECHNICAL FIELD

This application relates to the field of macromolecular materials, and specifically, to a holographic photopolymer material, a holographic photosensitive film, a holographic optical element, and a display device.

## BACKGROUND

In a holographic technology (Optical holography), based on optical interference and diffraction principles, a reference light wave is introduced to interfere with an object light wave, to record amplitude and phase information of the object light wave on a holographic recording medium in a form of interference fringe, and then the original object light wave is reproduced through diffraction of the light wave, to reproduce a three-dimensional image of an original object. The holographic technology may include a holographic recording process. The holographic recording process may be understood as recording/storing light information of an object according to an interference principle. Holography may include light information such as an amplitude and a phase of a light wave.

In the holographic technology, a holographic photosensitive film is usually used to record/store light information such as an amplitude and a phase of a light wave. A material used for the holographic photosensitive film may be referred to as a holographic recording medium. A holographic photopolymer material is a common holographic recording medium. As a type of holographic macromolecular material, the holographic photopolymer material attracts wide attention due to advantages such as a wide photosensitive range, easy manufacturing and transportation, and good long-term storage stability.

In recent years, application fields of the holographic technology are expanded. In some application fields, temperatures are high, for example, in application scenarios such as in-vehicle display and airborne display. A holographic photopolymer material disclosed in a related technology is prone to irregular motion of macromolecular chain segments in a high-temperature environment, causing problems such as a decrease in transmittance, an increase in haze, and a diffraction peak drift of a holographic optical element/holographic photosensitive film made from the holographic photopolymer material. This limits application of the holographic photopolymer material/holographic photosensitive film in fields such as in-vehicle display and airborne display.

## SUMMARY

This application discloses a holographic photopolymer material, a holographic photosensitive film, a holographic optical element, and a display device. The holographic photopolymer material includes a polymer matrix that has a crosslinked structure, or includes activation groups that may form a crosslinked structure. The holographic photopolymer material has good heat resistance.

A first aspect of this application discloses a holographic photopolymer material, including a polymer matrix, photopolymerizable monomers, and a photosensitizer. A molecular structure of the polymer matrix includes a linear structure, branch chains of the polymer matrix include activation groups, and the activation groups are available for a crosslinking reaction; and/or the molecular structure of the polymer matrix includes a crosslinked structure.

In this implementation, the holographic photopolymer material may include the polymer matrix, the photopolymerizable monomers, and the photosensitizer. The polymer matrix may provide force support for the holographic photopolymer material. The photosensitizer may absorb a light wave and produce active intermediates that enable polymerization of the photopolymerizable monomers. Under irradiation of a coherent light beam, the holographic photopolymer material may be divided into a coherent bright region and a coherent dark region. The photosensitizer in the coherent bright region may produce the active intermediates. The active intermediates promote polymerization of the photopolymerizable monomers to the coherent bright region to form monomer polymers. Finally, the coherent bright region and the coherent dark region have monomer polymers with different concentrations. An index of refraction of the photopolymerizable monomer is greater than an index of refraction of the polymer matrix, and correspondingly, an index of refraction of the monomer polymer is greater than the index of refraction of the polymer matrix. The coherent bright region and the coherent dark region have different indexes of refraction, to implement holographic recording/storage.

In addition, the polymer matrix whose molecular structure is the crosslinked structure has a high glass transition temperature, so that the holographic photopolymer material has good heat resistance.

A holographic photosensitive film/holographic optical element made from the holographic photopolymer material whose molecular structure is a linear structure and whose branch chains include the activation groups has good heat resistance. Specifically, a reaction condition may be controlled, so that the activation groups in the holographic photosensitive film/holographic optical element undergo the crosslinking reaction. That is, a molecular structure of a polymer matrix in the holographic photosensitive film/holographic optical element includes a crosslinked structure, so that the holographic photosensitive film/holographic optical element has good heat resistance.

It can be learned that the holographic photopolymer material disclosed in this implementation has good heat resistance. Alternatively, the holographic photosensitive film/holographic optical element made from the holographic photopolymer material disclosed in this implementation has good heat resistance. The holographic photopolymer material disclosed in this implementation may be used in fields such as in-vehicle display and airborne display.

With reference to a first implementation of the first aspect, the polymer matrix includes at least one of polymethacrylate, polymethacrylamide, polyacrylate, polyacrylamide, polyvinyl ether, polyvinyl ester, and polysiloxane.

In this implementation, the polymer matrix has a high glass transition temperature, and the polymer matrix having a high glass transition temperature can effectively overcome motion of macromolecular chain segments, so that the holographic photopolymer material has good heat resistance.

With reference to a second implementation of the first aspect, the polymer matrix includes a copolymer including at least two of the following substances: methacrylate, methacrylamide, acrylate, acrylamide, vinyl ether, vinyl ester, and siloxane.

In this implementation, the polymer matrix also has a high glass transition temperature, and the polymer matrix having a high glass transition temperature can effectively overcome motion of the macromolecular chain segments, so that the holographic photopolymer material has good heat resistance.

With reference to a third implementation of the first aspect, the activation group includes at least one of an epoxy group, vinyl ether, and an N-vinyl group.

In this implementation, the activation group may include the epoxy group, and the epoxy group has large rigidity. The polymer matrix includes active epoxy groups with large rigidity, and the polymer matrix has a high glass transition temperature. The polymer matrix having a high glass transition temperature can effectively overcome motion of the macromolecular chain segments, so that the holographic photopolymer material has good heat resistance.

With reference to a fourth implementation of the first aspect, a structural formula of the photopolymerizable monomer includes:

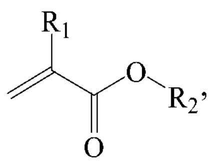

where $R_1$ includes H or $CH_3$; and $R_2$ includes at least one of 1,3-bis(thieno-2-ylthio)propan-2-yl, 1,3-bis((4-(phenylthio)phenyl)thio)propan-2-yl, and 1,3-bis((4-bromophenyl)thio)propan-2-yl.

In this implementation, sulfur atoms, aromatic rings, and benzene rings in $R_2$ all increase the index of refraction of the photopolymerizable monomer, so that the photopolymerizable monomer has a high index of refraction. The photopolymerizable monomer has a high index of refraction, and correspondingly, the monomer polymer also has a high index of refraction, to ensure that the coherent bright region and the coherent dark region of the holographic photosensitive film/holographic optical element made from the holographic photopolymer material disclosed in this implementation have high index-of-refraction contrast, and the high index-of-refraction contrast makes it easier to implement both high transmittance and high diffraction efficiency of the holographic photosensitive film/holographic optical element.

With reference to a fifth implementation of the first aspect, the holographic photopolymer material further includes a co-initiator. The co-initiator includes at least one of tetrabutylammonium tetrahexylborate, tetrabutylammonium hexyltrisphenylborate, tetrabutylammonium tris(3-fluoro-phenyl)hexylborate, and tetrabutylammonium tris(3-chloro-4-methylphenyl)hexylborate.

In this implementation, the co-initiator and the photosensitizer are used together, so that a rate of producing the active intermediates by the photosensitizer under excitation of the light wave can be increased.

With reference to a sixth implementation of the first aspect, an infrared spectrum of the holographic photopolymer material includes a first characteristic absorption peak and a second characteristic absorption peak. A wavenumber of the first characteristic absorption peak ranges from 877 $cm^{-1}$ to 831 $cm^{-1}$, and a wavenumber of the second characteristic absorption peak ranges from 829 $cm^{-1}$ to 787 $cm^{-1}$.

In this implementation, the holographic photopolymer material whose infrared spectrum includes the following is selected: The wavenumber of the first characteristic absorption peak ranges from 877 $cm^{-1}$ to 831 $cm^{-1}$, and the wavenumber of the second characteristic absorption peak ranges from 829 $cm^{-1}$ to 787 $cm^{-1}$. In this way, the holographic

photopolymer material having a high glass transition temperature can be obtained.

With reference to a seventh implementation of the first aspect, a ratio of a peak area of the first characteristic absorption peak to a peak area of the second characteristic absorption peak ranges from 0.4 to 8.8.

In this implementation, it is selected that the ratio of the peak area of the first characteristic absorption peak to the peak area of the second characteristic absorption peak ranges from 0.4 to 8.8, so that the glass transition temperature of the polymer matrix is further increased.

With reference to an eighth implementation of the first aspect, a nuclear magnetic resonance hydrogen spectrum of the holographic photopolymer material includes a third characteristic absorption peak and a fourth characteristic absorption peak. A chemical shift of the third characteristic absorption peak ranges from 3.2 ppm to 3.22 ppm, and a chemical shift of the fourth characteristic absorption peak ranges from 3.5 ppm to 3.7 ppm.

In this implementation, the holographic photopolymer material whose nuclear magnetic resonance hydrogen spectrum includes the following is selected: The chemical shift of the third characteristic absorption peak ranges from 3.2 ppm to 3.22 ppm, and the chemical shift of the fourth characteristic absorption peak ranges from 3.5 ppm to 3.7 ppm, so that the holographic photopolymer material having a high glass transition temperature can be obtained.

With reference to a ninth implementation of the first aspect, the glass transition temperature of the polymer matrix is greater than or equal to 50°C.

In this implementation, the glass transition temperature of the polymer matrix is greater than or equal to 50°C, and the polymer matrix has a high glass transition temperature. The polymer matrix having a high glass transition temperature can effectively overcome motion of the macromolecular chain segments, so that the holographic photopolymer material has good heat resistance.

A second aspect of this application discloses a holographic photosensitive film, including a protective layer and a first film layer covering the protective layer. The first film layer is made from the holographic photopolymer material disclosed in the first aspect.

For effect that can be achieved in the second aspect, refer to effect that can be achieved in any feasible implementation of the first aspect.

A third aspect of this application discloses a holographic optical element, including a protective layer and a second film layer covering the protective layer. Materials used for the second film layer include a polymer matrix and monomer polymers. A molecular structure of the polymer matrix includes a crosslinked structure. The second film layer includes a coherent bright region and a coherent dark region, and density of the monomer polymers in the coherent bright region is greater than density of the monomer polymers in the coherent dark region.

For effect that can be achieved in the third aspect, refer to effect that can be achieved in any feasible implementation of the first aspect.

With reference to a first implementation of the third aspect, an infrared spectrum of the second film layer includes a fifth characteristic absorption peak and a sixth characteristic absorption peak. A wavenumber of the fifth characteristic absorption peak ranges from 1768 $cm^{-1}$ to 1692 $cm^{-1}$, and a wavenumber of the sixth characteristic absorption peak ranges from 1093 $cm^{-1}$ to 1023 $cm^{-1}$.

In this implementation, the second film layer whose infrared spectrum includes the following is selected: The wavenumber of the fifth characteristic absorption peak ranges from 1768 $cm^{-1}$ to 1692 $cm^{-1}$, and the wavenumber of the sixth characteristic absorption peak ranges from 1093 $cm^{-1}$ to 1023 $cm^{-1}$. In this way, the holographic optical element having good thermal stability can be obtained.

With reference to a second implementation of the third aspect, a ratio of a peak area of the fifth characteristic absorption peak to a peak area of the sixth characteristic absorption peak ranges from 1.0 to 4.4.

In this implementation, it is selected that the ratio of the peak area of the fifth characteristic absorption peak to the peak area of the sixth characteristic absorption peak ranges from 1.0 to 4.4, so that the holographic optical element having good thermal stability can be obtained.

A fourth aspect of this application discloses a preparation method for a holographic photopolymer material, including: synthesizing a polymer matrix; and mixing the polymer matrix, photopolymerizable monomers, and a photosensitizer to obtain the holographic photopolymer material disclosed in the first aspect. A molecular structure of the polymer matrix includes a linear structure, branch chains of the polymer matrix include activation groups, and the activation groups are available for a crosslinking reaction.

For effect that can be achieved in the fourth aspect, refer to effect that can be achieved in any feasible implementation of the first aspect.

A fifth aspect of this application discloses a preparation method for a holographic photosensitive film, including: coating a protective layer with the holographic photopolymer material prepared in the fourth aspect; and converting the holographic photopolymer material into a first film layer. A molecular structure of a polymer matrix in the first film layer includes a linear structure, branch chains of the polymer matrix include activation groups, and the activation groups are available for a crosslinking reaction; and/or the molecular structure of the polymer matrix in the first film layer includes a crosslinked structure.

For effect that can be achieved in the fifth aspect, refer to effect that can be achieved in any feasible implementation of the first aspect.

A sixth aspect of this application discloses a preparation method for a holographic optical element, including: performing holographic processing on the holographic photosensitive film prepared in the fifth aspect, to convert the first film layer into a second film layer. The second film layer includes a coherent bright region and a coherent dark region. Density of monomer polymers in the coherent bright region is greater than density of the monomer polymers in the coherent dark region, and the monomer polymers are obtained through polymerization of the photopolymerizable monomers.

For effect that can be achieved in the sixth aspect, refer to effect that can be achieved in any feasible implementation of the first aspect.

A seventh aspect of this application discloses a display device, including a display and an optical element disposed on the display. The optical element includes the holographic photosensitive film disclosed in the second aspect or the holographic optical element disclosed in the third aspect.

For effect that can be achieved in the seventh aspect, refer to effect that can be achieved in any feasible implementation of the first aspect.

## BRIEF DESCRIPTION OF DRAWINGS

FIG. 1 is a mapping curve between transmittance of a holographic photopolymer material and wavelengths of an irradiating light wave in a process of heating the holographic photopolymer material at 100°C for 6 hours according to a feasible embodiment;
FIG. 2 is a flowchart of a preparation method for a holographic photosensitive film according to a feasible embodiment;
FIG. 3 is a diagram of a holographic photosensitive film according to a feasible embodiment;
FIG. 4 is a diagram of a holographic photosensitive film according to a feasible embodiment;
FIG. 5 is a flowchart of a preparation method for a holographic optical element according to a feasible embodiment;
FIG. 6 is a diagram of a principle of a reflection optical path for holographic recording according to a feasible embodiment;
FIG. 7 is a diagram of a principle of a transmission optical path for holographic recording according to a feasible embodiment; and
FIG. 8 is a flowchart of a holographic optical element according to a feasible embodiment.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

In the following, the terms "first", "second", and the like are merely used to distinguish between same items or similar items with basically the same functions and functions for a purpose of description, and cannot be understood as an indication or implication of relative importance or an implicit indication of a quantity of indicated technical features. Therefore, a feature limited by "first", "second", or the like may explicitly or implicitly include one or more features.

In addition, in descriptions of this application, unless otherwise specified, "a plurality of' means two or more than two.

In addition, in this application, orientation terms such as "up", "down", "left", "right", "horizontal", and "vertical" are defined relative to an orientation in which components are schematically placed in the accompanying drawings. It should be understood that, these directional terms are relative concepts that are used for relative description and clarification, and may vary accordingly based on changes of the orientation in which the components are placed in the accompanying drawings. Unless otherwise expressly specified and limited, the term "connection" should be understood in a broad sense. For example, the "connection" may be a fixed connection, a detachable connection, or an integrated connection, or may be a direct connection or an indirect connection implemented through an intermediate medium.

In addition, in embodiments of this application, a term such as "example" or "for example" represents giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

First, concepts in embodiments of this application are described.

Interference (interference) is a phenomenon that when two or more columns of waves meet in space, the two or

more columns of waves are superposed or canceled, thereby forming a new waveform.

An amplitude (amplitude) is a maximum value that vibration of a light wave may reach.

A phase (phase) is a position of a light wave in a cycle of the light wave at a specific moment.

A light beam (light beam) is a form of light wave, and is specifically a beam-shaped light wave.

A macromolecular compound (macromolecular compound) is usually a compound with relative molecular mass ranging from several thousand to several million, and has excellent mechanical performance.

A linear structure (linear structure) is a structure of a macromolecular compound. An entire molecule of a linear structure resembles a long chain.

A crosslinked structure (crosslinked structure), also known as a network structure, is a three-dimensional mesh structure of a macromolecular compound.

Diffraction efficiency (diffraction efficiency, DE) is an important parameter of a holographic photopolymer material, and is a ratio of light intensity in a diffraction direction to intensity of incident light.

An index-of-refraction degree of modulation (index-of-refraction degree of modulation) is an important parameter of a holographic photopolymer material, and reflects a degree to which the holographic photopolymer material is controlled by a light wave signal.

Transmittance (transmittance) is an important parameter of a holographic photopolymer material, which may be represented by a ratio of luminous flux passing through the holographic photopolymer material to incident luminous flux of the holographic photopolymer material.

Haze (haze) is an important parameter of a holographic photopolymer material, which may be represented by a ratio of scattering luminous flux to luminous flux passing through the holographic photopolymer material.

A glass transition temperature (glass transition temperature, Tg) is a corresponding temperature at which a glass state changes to a high elastic state. Tg is a lowest temperature at which a molecular chain can move.

A holographic technology, also referred to as a virtual imaging technology, uses interference and diffraction principles to record and reproduce a real three-dimensional image of an object. A holographic projection technology may include a holographic recording process and a holographic reproduction process.

The holographic recording process may be understood as recording light information of an object according to the interference principle. Specifically, a part of light beams irradiating a photographed object may form object light beams related to the photographed object; and the other part of light beams irradiates a holographic film (the holographic film in embodiments of this application may also be referred to as a holographic photopolymer material) as reference light beams, and the reference light beams may be superimposed with the object light beams to generate interference. In the foregoing manner, a phase and an amplitude of each point on the object light beams related to the photographed object are converted into intensity that changes in space, so as to record all light information (which is briefly referred to as holography in embodiments of this application) of the object light beams based on contrast and a spacing between interference fringes. The light information may include a phase and an amplitude. In embodiments of this application, a holographic film recording the interference fringe may be referred to as a holographic photosensitive film.

The holographic reproduction process may be understood as an imaging process. A hologram, or referred to as a holographic photo, is obtained after the holographic film recording the interference fringe undergoes processing procedures such as development and fixation. Specifically, the hologram may be understood as a holographic optical element. Under irradiation of a coherent light beam, a diffractive light wave of the holographic optical element may usually provide two images, to be specific, an original image (also referred to as an initial image) and a conjugate image. The two images may provide a user with real visual effect with a strong stereoscopic feeling. Each part of the hologram records light information of each point on the photographed object. Therefore, in principle, each part of the hologram can reproduce an entire image of the photographed object. A plurality of different images may further be recorded on a same film through a plurality of exposures, and can be displayed separately without mutual interference.

It can be learned that because light information such as an amplitude and a phase of a light wave can be stored, the holographic technology has been widely used in high-tech fields such as holographic optical element manufacturing, high-density holographic storage, high-end anti-counterfeiting, and additive manufacturing.

It can be learned that in the holographic technology, the holographic photosensitive film is used to record/store light information such as an amplitude and a phase of a light wave. A material used for the holographic photosensitive film may be referred to as a holographic recording medium. A holographic macromolecular material is a common holographic recording medium.

The holographic macromolecular material uses a macromolecular compound as a medium to store/record light information such as an amplitude and a phase of a light wave.

As a type of holographic macromolecular material, the holographic photopolymer material attracts wide attention due to advantages such as a wide photosensitive range, easy manufacturing and transportation, and good long-term storage stability. The following describes the holographic photopolymer material.

The holographic photopolymer material may include a photosensitizer, a polymer matrix, and photopolymerizable monomers.

The polymer matrix may provide force support for the holographic photopolymer material. An index of refraction (index of refraction) of the polymer matrix is usually low (the index of refraction<1.5).

The photosensitizer may absorb radiation energy of a light wave, and produce, through a chemical change, active intermediates that promote polymerization of the photopolymerizable monomers.

An index of refraction of the photopolymerizable monomer is usually high (the index of refraction>1.5). During holographic processing, the photopolymerizable monomers may polymerize into photopolymers (which may also be referred to as monomer polymers in embodiments of this application) under an action of the active intermediates produced by the photosensitizer. An index of refraction of the photopolymer is greater than the index of refraction of the polymer matrix. There is a difference between the indexes of refraction of the photopolymer and the polymer matrix, to form a periodic phase separation structure and an index-of-refraction degree of modulation.

The phase separation structure of the holographic photopolymer material may be controlled by changing parameters such as wavelengths, a quantity of light beams, and an intersection angle of coherent light beams. Usually, main parameters for evaluating performance of the holographic photopolymer material include diffraction efficiency, the index-of-refraction degree of modulation, transmittance, haze, and the like.

The following describes two holographic photopolymer materials disclosed in related technologies.

A related technology 1 discloses a holographic photopolymer material, and the holographic photopolymer material in the related technology 1 may include:

(a) a polymer adhesive, where the polymer adhesive may be selected from one of the following groups: polyvinyl acetate, polyvinyl butyral, polyvinyl acetal, and polyvinyl formal, a copolymer including main chain segments thereof, and a mixture thereof;
(b) unsaturated photopolymerizable monomers including alkene, which may be selected from one of the following groups: photopolymerizable monomers including carbazole, and liquid photopolymerizable monomers including one phenyl group or a plurality of phenyl groups, phenoxy groups, naphthyl groups, naphthyloxy groups, and aromatic heterocycles including up to three aromatic rings, chlorine, and bromine; and
(c) a photoinitiator system that may be activated by light irradiation.

The holographic photopolymer material disclosed in the related technology 1 has excellent diffraction efficiency and index-of-refraction degree of modulation. However, when the holographic photopolymer material disclosed in the related technology 1 is heated, problems such as an irreversible diffraction peak wavelength drift, a decrease in transmittance, and an increase in haze exist.

A related technology 2 discloses a holographic photopolymer material. The holographic photopolymer material may include:

(a) a polymer matrix (aromatic-based, aromatic aliphatic-based, aliphatic-based, or alicyclic-based polyurethane);
(b) photopolymerizable monomers (acrylate/urethane acrylate with an index of refraction greater than 1.50); and
(c) a photoinitiator system (cationic dyes, anionic dyes, neutral dyes and a co-initiator).

The holographic photopolymer material disclosed in the related technology 2 uses in-situ crosslinked polyurethane as the polymer matrix, which improves heat resistance of the holographic photopolymer material to some extent. In order to meet a requirement of high index-of-refraction degree of modulation, the holographic photopolymer material disclosed in the related technology uses polyurethane with low crosslink density as the polymer matrix. As a result, when heated for a long time, the holographic photopolymer material disclosed in the related technology 2 is also prone to problems such as an irreversible diffraction peak wavelength drift, a decrease in transmittance, and an increase in haze.

It can be learned that the holographic photopolymer material disclosed in the related technologies may have excellent diffraction efficiency, index-of-refraction degree of modulation ($\delta n$), transmittance, haze, and the like.

In recent years, application fields of the holographic photopolymer material are expanded. In some fields, the holographic photopolymer material is at high ambient temperatures, for example, in application scenarios such as in-vehicle display and airborne display. In the foregoing application scenarios, ambient temperatures are high. The holographic optical element obtained by using the holographic photopolymer material disclosed in the related technology is prone to motion of macromolecular chain segments in a high-temperature environment, and the holographic photopolymer material has poor heat resistance. This limits application of the holographic photopolymer material in fields such as in-vehicle display and airborne display.

To improve heat resistance of the holographic photopolymer material, an embodiment of this application discloses a holographic photopolymer material. The holographic photopolymer material may include a polymer matrix, photopolymerizable monomers, and a photosensitizer.

The polymer matrix may provide force support for the holographic photopolymer material. The photopolymerizable monomers and the photosensitizer are dispersed in the polymer matrix. The photosensitizer may absorb a light wave

and produce active intermediates that enable polymerization of the photopolymerizable monomers. Under irradiation of a coherent light beam, the holographic photopolymer material may be divided into a coherent bright region and a coherent dark region. The photosensitizer in the coherent bright region may produce the active intermediates. The active intermediates promote polymerization of the photopolymerizable monomers to the coherent bright region to form monomer polymers. Finally, the coherent bright region and the coherent dark region have monomer polymers with different concentrations. An index of refraction of the photopolymerizable monomer is greater than an index of refraction of the polymer matrix, and correspondingly, an index of refraction of the monomer polymer is greater than the index of refraction of the polymer matrix. Therefore, the coherent bright region and the coherent dark region have different indexes of refraction, to implement holographic recording/storage.

The polymer matrix whose molecular structure is a crosslinked structure has a high glass transition temperature, so that the holographic photopolymer material has good heat resistance.

A holographic photosensitive film/holographic optical element made from the holographic photopolymer material whose molecular structure is a linear structure and whose branch chains include activation groups has good heat resistance. Specifically, a reaction condition may be controlled, so that activation groups in the holographic photosensitive film/holographic optical element undergo a crosslinking reaction. That is, a molecular structure of a polymer matrix in the holographic photosensitive film/holographic optical element includes a crosslinked structure, so that the holographic photosensitive film/holographic optical element has good heat resistance.

The following further describes components of the holographic photopolymer material.

In this embodiment of this application, the holographic photopolymer material may include the polymer matrix.

In this embodiment of this application, the polymer matrix includes a macromolecular compound formed by connecting a plurality of repeating units. The polymer matrix may provide force support for the holographic photopolymer material.

In this embodiment of this application, the repeating units (repeating units) may be understood as minimum units that are in the polymer matrix and whose chemical composition is the same.

A type of the repeating unit is not specifically limited in this embodiment of this application. Any substances that may be connected to form a polymer matrix whose glass transition temperature is greater than or equal to 50°C may be used in this embodiment of this application as repeating units.

In a feasible implementation, the repeating unit may include at least one of methacrylate, methacrylamide, polyacrylate, polyacrylamide, polyvinyl ether, polyvinyl ester, and polysiloxane, and polysiloxane, and the repeating units all have polar groups. There is a strong interaction between the polar groups, so that the repeating unit has a high glass transition temperature, and correspondingly, the polymer matrix formed by connecting the foregoing repeating units also has a high glass transition temperature. The polar groups (polar groups) may include but are not limited to a carbonyl group, an amide group, an ether group, a silane group, and the like.

The following describes the glass transition temperature of the repeating unit by using acrylate as an example.

A structural formula of acrylate is as follows:

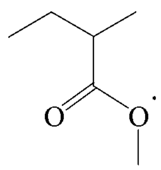

Acrylate includes a polar group: a carbonyl group

( 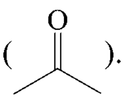 ).

There is a strong interaction between carbonyl groups, so that methacrylate has a high glass transition temperature.

In some feasible implementations, the polymer matrix may include at least one homopolymer.

The homopolymer may be understood as a macromolecular compound formed through polymerization of one type of repeating unit. For example, the polymer matrix may include at least one of polymethacrylate (for a structural formula, refer to the following structural formula I), polymethacrylamide (for a structural formula, refer to the following structural formula II), polyacrylate (for a structural formula, refer to the following structural formula III), polyacrylamide (for a structural formula, refer to the following structural formula IV), polyvinyl ether (for a structural formula, refer to the following structural formula V), polyvinyl ester (for a structural formula, refer to the following structural formula VI), and polysiloxane (for a structural formula, refer to the following structural formula VII).

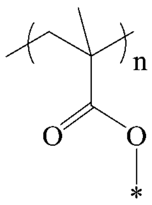

structural formula I,

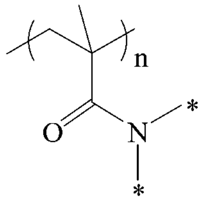

structural formula II,

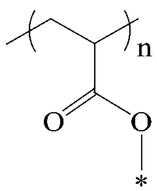

structural formula III,

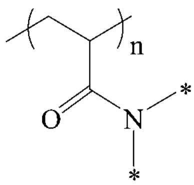

structural formula IV,

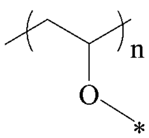

structural formula V,

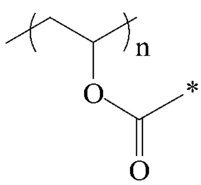

structural formula VI, and

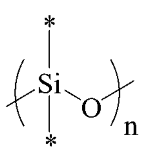

structural formula VII, where n represents a quantity of repeating units, and * represents a bonding site.

It should be noted that this embodiment of this application merely describes examples of several homopolymers that may be included in the polymer matrix. The foregoing types of homopolymers do not constitute a specific limitation.

The polymer matrix disclosed in this implementation has a high glass transition temperature, and the polymer matrix having a high glass transition temperature can effectively overcome motion of macromolecular chain segments, so that the holographic photopolymer material has good heat resistance.

In some feasible implementations, the polymer matrix may include at least one copolymer (copolymer). The copolymer may be understood as a macromolecular compound formed through polymerization of at least two types of repeating units. For example, the polymer matrix may include at least one of a copolymer including methacrylate and methacrylamide, a copolymer including acrylate and polyacrylamide, and a copolymer including vinyl ether, vinyl ester, and siloxane.

It should be noted that this embodiment of this application merely describes examples of several copolymers that may be included in the polymer matrix. The foregoing types of copolymers do not constitute a specific limitation.

The polymer matrix disclosed in this implementation has a high glass transition temperature, and the polymer matrix having a high glass transition temperature can effectively overcome motion of the macromolecular chain segments, so that the holographic photopolymer material has good heat resistance.

In some feasible implementations, the polymer matrix may include at least one copolymer and at least one homopolymer. For a type of the copolymer and a type of the homopolymer, refer to the foregoing embodiment. Details are not described herein again.

In this embodiment of this application, the polymer matrix includes the macromolecular compound formed by connecting the plurality of repeating units. In some feasible implementations, the molecular structure of the polymer matrix may include the linear structure, and the branch chains of the polymer matrix include the activation groups (activation groups). In this embodiment of this application, the activation groups may be understood as groups that may undergo the crosslinking reaction.

In a feasible implementation, the branch chains of the polymer matrix may undergo the crosslinking reaction. That is, the molecular structure of the polymer matrix is the crosslinked structure (crosslinked structure).

The polymer matrix including the crosslinked structure has a high glass transition temperature, and the polymer matrix having a high glass transition temperature can effectively overcome motion of the macromolecular chain segments, so that the holographic photopolymer material has good heat resistance.

In an embodiment in which the polymer matrix includes the activation groups, in a feasible implementation, the branch chains of the polymer matrix may not undergo the crosslinking reaction. That is, the molecular structure of the polymer matrix is the linear structure. The polymer matrix including the linear structure has good fluidity, and a corresponding holographic photopolymer material has excellent coating performance.

In the embodiment in which the polymer matrix includes the activation groups, in a feasible implementation, a part of the branch chains of the polymer matrix may undergo the crosslinking reaction. That is, the molecular structure of the polymer matrix includes the linear structure and the crosslinked structure.

A type of the activation group is not specifically limited in this embodiment of this application. Any groups that may undergo the crosslinking reaction may be used in this embodiment of this application as activation groups.

For example, the activation groups may include vinyl ether (for a structural formula, refer to a structural formula VIII) and an N-vinyl group (for a structural formula, refer to a structural formula IX).

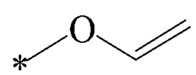

structural formula VII and

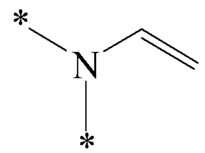

structural formula IX, where * represents a bonding site.

It should be noted that, this embodiment of this application merely describes examples of two types of activation groups, and the foregoing activation groups do not constitute a specific limitation.

In a feasible implementation, the photosensitizer produces the active intermediates under a first condition, the activation groups on the branch chains of the polymer matrix undergo the crosslinking reaction under a second condition, and the first condition and the second condition do not overlap.

In this embodiment of this application, the first condition includes a condition for exciting the photosensitizer to produce the active intermediates. The second condition includes a condition for exciting the crosslinking reaction of the activation groups. That the first condition and the second condition do not overlap may be understood as that, under the first condition, the activation groups do not undergo the crosslinking reaction.

The first condition may include irradiation. For example, the first condition may include irradiation in a wavelength range of 400 nm to 800 nm.

The second condition is not specifically limited in embodiments of this application.

In a feasible implementation, the second condition may include irradiation. However, it needs to be ensured that a wavelength range of a light wave required in the second condition does not overlap a wavelength range of a light wave required in the first condition. For example, the wavelength range required in the first condition is 400 nm to 800 nm, and a wavelength required in the second condition may be less than 400 nm or greater than 800 nm.

In a feasible implementation, the second condition may include a non-irradiation condition. For example, the non-irradiation condition may include but is not limited to a high temperature, electrophilic catalysis, and the like.

In this implementation, the molecular structure of the polymer matrix of the holographic photopolymer material includes the linear structure, and the branch chains of the polymer matrix include the activation groups. The molecular structure of the polymer matrix includes the linear structure, so that the holographic photopolymer material has good coating performance.

The holographic photosensitive film made from the holographic photopolymer material may have high data recording/storage efficiency. Specifically, the reaction condition may be controlled, so that the activation groups of the holographic photosensitive film do not undergo the crosslinking reaction in a holographic processing process. That is, in the holographic processing process, the molecular structure of the polymer matrix in the holographic photosensitive film includes a linear structure. The polymer matrix of the linear structure has small migration resistance to the photopolymerizable monomers, which facilitates migration of the photopolymerizable monomers to the coherent bright region. Therefore, the holographic photosensitive film made from the holographic photopolymer material disclosed in this implementation may have high data recording/storage efficiency.

The holographic photosensitive film (which may be referred to as the holographic optical element in this embodiment of this application) with holographic recording may have good heat resistance. Specifically, the polymer matrix in the holographic optical element includes the activation groups. An experimental condition is controlled, so that the activation groups undergo the crosslinking reaction. That is, the polymer matrix in the holographic optical element is of the crosslinked structure. A holographic optical element with good heat resistance may be obtained by using the holographic photopolymer material disclosed in this implementation.

In a feasible implementation, the activation group may include an epoxy group (epoxy group).

A quantity of atoms forming a ring in the epoxy group is not specifically limited in this embodiment of this application. For example, the activation group may include a ternary epoxy group (for a structural formula, refer to a structural formula X), a quaternary epoxy group (for a structural formula, refer to a structural formula XI), and a quinary epoxy group (for a structural formula, refer to a structural formula XII). In this embodiment of this application, an activation group including the epoxy group may be referred to as an active epoxy group.

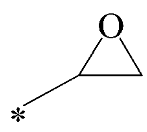

structural formula X,

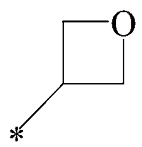

structural formula XI, and

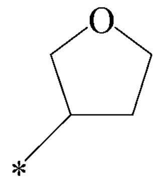

structural formula XII, where * represents a bonding site.

It should be noted that, this embodiment of this application merely describes examples of three types of active epoxy groups, and the foregoing active epoxy groups do not constitute a specific limitation.

The active epoxy group has large rigidity, so that the polymer matrix has large rigidity. The glass transition temperature of the polymer matrix is related to rigidity of the polymer matrix. Larger rigidity of the polymer matrix indicates better heat resistance of the polymer matrix. In this implementation, the polymer matrix includes active epoxy groups with large rigidity, and the polymer matrix has a high glass transition temperature. The polymer matrix having a high glass transition temperature can effectively overcome motion of the macromolecular chain segments, so that the holographic photopolymer material has good heat resistance.

The holographic photopolymer material includes the epoxy group/an ether bond (-O-), so that an infrared spectrum of the holographic photopolymer material includes a first characteristic absorption peak. The holographic photopolymer material includes acrylate/the carbonyl group, so that the infrared spectrum of the holographic photopolymer material includes a second characteristic absorption peak. A wavenumber of the first characteristic absorption peak ranges from 877 $cm^{-1}$ to 831 $cm^{-1}$, and a wavenumber of the second characteristic absorption peak ranges from 829 $cm^{-1}$ to 787 $cm^{-1}$.

The holographic photopolymer material whose infrared spectrum includes the following is selected: The wavenumber of the first characteristic absorption peak ranges from 877 $cm^{-1}$ to 831 $cm^{-1}$, and the wavenumber of the second characteristic absorption peak ranges from 829 $cm^{-1}$ to 787 $cm^{-1}$. In this way, the holographic photopolymer material having a high glass transition temperature can be obtained.

It is selected that a ratio of a peak area of the first characteristic absorption peak to a peak area of the second characteristic absorption peak ranges from 0.4 to 8.8, so that the glass transition temperature of the polymer matrix is further increased.

The holographic photopolymer material includes the epoxy group/the ether bond, so that a nuclear magnetic resonance hydrogen spectrum of the holographic photopolymer material includes a third characteristic absorption peak. The holographic photopolymer material includes acrylate/the carbonyl group, so that the nuclear magnetic resonance hydrogen spectrum of the holographic photopolymer material includes a fourth characteristic absorption peak. A chemical shift of the third characteristic absorption peak ranges from 3.2 ppm to 3.22 ppm, and a chemical shift of the fourth characteristic absorption peak ranges from 3.5 ppm to 3.7 ppm.

The holographic photopolymer material whose nuclear magnetic resonance hydrogen spectrum includes the following is selected: The chemical shift of the third characteristic absorption peak ranges from 3.2 ppm to 3.22 ppm, and the chemical shift of the fourth characteristic absorption peak ranges from 3.5 ppm to 3.7 ppm, so that the holographic photopolymer material having a high glass transition temperature can be obtained.

In a feasible implementation, the glass transition temperature of the polymer matrix is greater than or equal to 50°C.

In this implementation, the glass transition temperature of the polymer matrix is greater than or equal to 50°C, and the polymer matrix has a high glass transition temperature. The polymer matrix having a high glass transition temperature can effectively overcome motion of the macromolecular chain segments, so that the holographic photopolymer material has good heat resistance.

So far, descriptions of the polymer matrix are completed.

In this embodiment of this application, the holographic photopolymer material may include the photosensitizer.

The photosensitizer (photosensitizer) may be understood as a substance that may undergo, after being excited by a light wave, a photochemical change to produce the active intermediates.

A type of the photosensitizer is not specifically limited in this embodiment of this application. Any substance that may produce, after being excited by a light wave, active intermediates having a capability of triggering polymerization of the photopolymerizable monomers may be used in this embodiment of this application as a photosensitizer.

In a feasible implementation, the photosensitizer may include at least one of acridine orange, eosin B, erythrosine B, rose bengal, phloxine, rhodamine B, methyl blue, methylene blue, 3,3'-carbonylbis(7-diethylaminocoumarin), and 2,5-bis(4-diethylaminobenzylidene)cyclopentanone. The foregoing photosensitizer has a stable structure, is not easy to turn yellow, and is easy to bleach, which ensures that the holographic photosensitive film/holographic optical element prepared by using the holographic photopolymer material disclosed in this implementation has large transmittance.

The photosensitizer can produce the active intermediates under a light wave of 400 nm to 800 nm. A local

irradiation manner may be used, so that a photosensitizer in the coherent bright region produces the active intermediates, and a photosensitizer in the coherent dark region does not produce the active intermediates or produces few active intermediates. The active intermediates promote polymerization of the photopolymerizable monomers to the coherent bright region to form the monomer polymers. Finally, the coherent bright region and the coherent dark region have the monomer polymers with different concentrations. The coherent bright region and the coherent dark region have different indexes of refraction, to implement holographic recording/storage.

In this embodiment of this application, the active intermediate may be understood as an intermediate that may trigger a polymerization reaction of the photopolymerizable monomers. The active intermediate may include but is not limited to a free radical active species and/or a cationic active species.

For example, the free radical active species may include but is not limited to a phenyl free radical and an alkyl free radical.

For example, the cationic active species may include but is not limited to protons. In this embodiment of this application, the protons may come from acid substances such as hexafluorophosphoric acid ($HPF_6$) and hexafluoroantimonic acid ($HSbF_6$).

To improve holographic storage/recording efficiency of the holographic photosensitive film made from the holographic photopolymer material, in a feasible implementation, the holographic photopolymer material may further include a co-initiator.

The co-initiator (co-initiator) is used together with the photosensitizer, so that a rate of producing the active intermediates by the photosensitizer under excitation of a light wave can be accelerated, and holographic storage/recording efficiency of the holographic photosensitive film made from the holographic photopolymer material can be improved.

A type of the co-initiator is not specifically limited in this embodiment of this application. Any substance that may accelerate a rate of producing the active intermediates by the photosensitizer under excitation of a light wave may be used in this embodiment of this application as a co-initiator.

For example, the co-initiator may include at least one of N-phenylglycine, triethanolamine, triisopropanolamine, methyldiethanolamine, chlorodiphenyl iodinium salt, and hexafluorophosphate diphenyl iodinium salt. The foregoing co-initiator may accelerate the rate of producing the active intermediates by the photosensitizer under excitation of the light wave, so that holographic storage/recording efficiency of the holographic photopolymer material can be improved.

In a feasible implementation, the co-initiator further includes at least one of tetrabutylammonium tetrahexylborate, tetrabutylammonium hexyltrisphenylborate, tetrabutylammonium tris(3-fluoro-phenyl)hexylborate, and tetrabutylammonium tris(3-chloro-4-methylphenyl)hexylborate.

So far, descriptions of the photosensitizer/co-initiator are completed.

In this embodiment of this application, the holographic photopolymer material may include the photopolymerizable monomers.

In this embodiment of this application, the photopolymerizable monomers (monomers/momers) are simple compounds that can be polymerized under an action of the active intermediates. The index of refraction of the photopolymerizable monomer is greater than the index of refraction of the polymer matrix.

In this embodiment of this application, a compound formed through polymerization of the photopolymerizable monomers may be referred to as the monomer polymer, and the index of refraction of the monomer polymer is greater than an index of refraction of the holographic photopolymer material.

Under irradiation of the coherent light beam, the photosensitizer in the coherent bright region may produce the active intermediates. The active intermediates promote polymerization of the photopolymerizable monomers to the coherent bright region to form the monomer polymers. Finally, the coherent bright region and the coherent dark region have the monomer polymers with different concentrations. The coherent bright region and the coherent dark region have different indexes of refraction, to implement holographic recording/storage.

A type of the photopolymerizable monomer is not specifically limited in this embodiment of this application. Any substance that can be polymerized under an action of the active intermediates and whose index of refraction is greater than the index of refraction of the polymer matrix may be used in this embodiment of this application as a photopolymerizable monomer.

In a feasible implementation, the photopolymerizable monomer may include a chlorine atom (Cl), a bromide atom (Br), an iodine atom (I), an aromatic ring, and a benzene ring. The atom or group may improve an index of refraction of the photopolymerizable monomer, so that a coherent bright region and a coherent dark region of the holographic optical element obtained after holographic processing have a high index-of-refraction contrast, and it is easier to implement high transmittance and high diffraction efficiency of the holographic optical element.

For example, a structural formula of the photopolymerizable monomer may include a structural formula i.

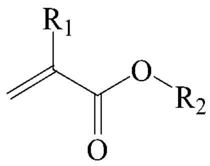

structural formula i.

In the structural formula i, $R_1$ may include H or $CH_3$.

$R_2$ may include at least one of phenylethyl, phenoxyethyl, ortho-phenylphenethoxy, 4-(1-methyl-1-phenylethyl) phenoxyethyl, 2,4,6-tribromophenyl, 2,4,6-tribromophenoxyethyl, pentabromophenyl, pentabromophenoxy, naphthyl, and naphthoxy. Aromatic rings, benzene rings, and Br in $R_2$ all may increase the index of refraction of the photopolymerizable monomer, so that the photopolymerizable monomer has a high index of refraction.

In a feasible implementation, $R_2$ in the structural formula i may include 1,3-bis(thieno-2-ylthio)propan-2-yl, 1,3-bis((4-(phenylthio)phenyl)thio)propan-2-yl, and 1,3-bis((4-bromophenyl)thio)propan-2-yl. Sulfur (S) atoms, aromatic rings, and benzene rings in $R_2$ all increase the index of refraction of the photopolymerizable monomer, so that the photopolymerizable monomer has a high index of refraction. The photopolymerizable monomer has a high index of refraction, and correspondingly, the monomer polymer also has a high index of refraction, to ensure that the coherent bright region and the coherent dark region of the holographic photosensitive film/holographic optical element made from the holographic photopolymer material disclosed in this implementation have high index-of-refraction contrast, and the high index-of-refraction contrast makes it easier to implement high transmittance and high diffraction efficiency of the holographic photosensitive film/holographic optical element.

In a feasible implementation, the holographic photopolymer material may be completely dissolved by dichloromethane before a photoreaction, and an obtained solution may produce a precipitate in n-hexane.

The following describes heat resistance of the holographic photopolymer material disclosed in this embodiment of this application with reference to a specific accompanying drawing. FIG. 1 is a mapping curve between transmittance of a holographic photopolymer material and wavelengths of an irradiating light wave in a process of heating the holographic photopolymer material at 100°C for 6 hours according to a feasible embodiment.

For a mapping curve between the transmittance of the holographic photopolymer material and the wavelengths of the irradiating light wave at an initial time (at a room temperature), refer to (1) in FIG. 1.

For a mapping curve between the transmittance of the holographic photopolymer material and the wavelengths of the irradiating light wave after heating at 100°C for 1 h, refer to (2) in FIG. 1.

For a mapping curve between the transmittance of the holographic photopolymer material and the wavelengths of the irradiating light wave after heating at 100°C for 2 h, refer to (3) in FIG. 1.

For a mapping curve between the transmittance of the holographic photopolymer material and the wavelengths of the irradiating light wave after heating at 100°C for 3 h, refer to (4) in FIG. 1.

For a mapping curve between the transmittance of the holographic photopolymer material and the wavelengths of the irradiating light wave after heating at 100°C for 4 h, refer to (5) in FIG. 1.

For a mapping curve between the transmittance of the holographic photopolymer material and the wavelengths of the irradiating light wave after heating at 100°C for 5 h, refer to (6) in FIG. 1.

For a mapping curve between the transmittance of the holographic photopolymer material and the wavelengths of the irradiating light wave after heating at 100°C for 6 h, refer to (7) in FIG. 1.

It can be learned that a decrease degree of the transmittance is small in the process of heating the holographic photopolymer material disclosed in this embodiment at 100°C for 6 h, and the holographic photopolymer material disclosed in this embodiment of this application has good heat resistance.

An embodiment of this application further discloses a holographic photosensitive film. The holographic photosensitive film includes a protective layer and a first film layer covering the protective layer. The first film layer is obtained through curing of the holographic photopolymer material disclosed in this embodiment of this application. The first film layer includes a polymer matrix, photopolymerizable monomers, and a photosensitizer. The polymer matrix may provide force support for the first film layer. The photosensitizer may absorb a light wave and produce an active intermediates that enable polymerization of the photopolymerizable monomers. Under irradiation of a coherent light beam, the first film layer may be divided into a coherent bright region and a coherent dark region. The photosensitizer in the coherent bright region may produce active intermediates. The active intermediates may promote polymerization of the photopolymerizable monomers to the coherent bright region to form monomer polymers. Finally, the coherent bright region and the coherent dark region have the monomer polymers with different concentrations. An index of refraction of the photopolymerizable monomer is greater than an index of refraction of the polymer matrix. Correspondingly, an index of refraction of the monomer polymer is greater than the index of refraction of the polymer matrix. The coherent bright region and the coherent dark region have different index of refractions, to implement holographic recording/storage.

In a feasible implementation, a molecular structure of the polymer matrix in the first film layer is a linear structure,

and branch chains include activation groups. The polymer matrix of the linear structure has small migration resistance to the photopolymerizable monomers, which facilitates migration of the photopolymerizable monomers to the coherent bright region. The holographic photosensitive film has high information recording/storage efficiency.

A holographic optical element obtained through holographic recording permade from the holographic photosensitive film disclosed in this implementation has good heat resistance. Specifically, the polymer matrix in the holographic photosensitive film includes the activation groups. After holographic recording is completed, the holographic photosensitive film is converted into the holographic optical element, where a polymer matrix in the holographic optical element includes activation groups. A condition may be controlled, so that the activation groups of the holographic optical element undergo a crosslinking reaction. In this way, the polymer matrix in the holographic optical element is of a crosslinked structure. The holographic optical element made from the holographic photosensitive film disclosed in this implementation can have good heat resistance.

In a feasible implementation, the molecular structure of the polymer matrix in the holographic photosensitive film includes a crosslinked structure. The polymer matrix including the crosslinked structure has a high glass transition temperature, so that the holographic photopolymer material has a high glass transition temperature. Correspondingly, the holographic photosensitive film has good heat resistance.

An embodiment of this application further discloses a holographic optical element, including a protective layer and a second film layer covering the protective layer. Materials used for the second film layer include a polymer matrix and monomer polymers. An index of refraction of the monomer polymer is greater than an index of refraction of the polymer matrix. A molecular structure of the polymer matrix includes a crosslinked structure. The second film layer includes a coherent bright region and a coherent dark region, and density of the monomer polymers in the coherent bright region is greater than density of the monomer polymers in the coherent dark region. The monomer polymer is used to form index-of-refraction distribution for holographic recording. An index of refraction of a region in which the monomer polymers gather (the coherent bright region) is high, and a region that does not include the monomer polymers or a region with fewer monomer polymers gathered (the coherent dark region) may be understood as a background. An index of refraction of the background is low, and the monomer polymers may form, together with the background, the index-of-refraction distribution for holographic recording.

The molecular structure of the polymer matrix in the second film layer is of the crosslinked structure. The polymer matrix of the crosslinked structure has a high glass transition temperature, so that the holographic optical element has good heat resistance.

The polymer matrix in the holographic optical element includes acrylate/a carbonyl group, so that an infrared spectrum of the holographic optical element includes a fifth characteristic absorption peak. The polymer matrix includes an epoxy group/ether bond, so that the infrared spectrum of the holographic optical element includes a sixth characteristic absorption peak. A wavenumber of the fifth characteristic absorption peak ranges from 1768 $cm^{-1}$ to 1692 $cm^{-1}$, and a wavenumber of the sixth characteristic absorption peak ranges from 1093 $cm^{-1}$ to 1023 $cm^{-1}$.

The holographic optical element whose infrared spectrum includes the following is selected: The wavenumber of the fifth characteristic absorption peak ranges from 1768 $cm^{-1}$ to 1692 $cm^{-1}$, and the wavenumber of the sixth characteristic absorption peak ranges from 1093 $cm^{-1}$ to 1023 $cm^{-1}$. In this way, the holographic optical element having good thermal stability can be obtained.

It is selected that a ratio of a peak area of the fifth characteristic absorption peak to a peak area of the sixth characteristic absorption peak ranges from 1.0 to 4.4, so that the holographic optical element having good thermal stability can be obtained.

In a feasible implementation, the holographic optical element may include a reflective holographic optical element and/or a transmission holographic optical element.

The reflective holographic optical element may be used as a coupling-in/coupling-out element for an optical waveguide. The reflective holographic optical element may alternatively be used in the AR display field. Specifically, the reflective holographic optical element may be used as an optical stacker in spatial direct-projection AR display, as a scattering element, or the like.

The transmission holographic optical element may be used as a coupling-in/coupling-out element for an optical waveguide, as a scattering element, or the like.

Based on a same technical concept, an embodiment of this application further discloses a preparation method for a holographic photopolymer material, including: synthesizing a polymer matrix; and mixing the polymer matrix, photopolymerizable monomers, and a photosensitizer to obtain the holographic photopolymer material disclosed in embodiments of this application. A molecular structure of the polymer matrix includes a linear structure, branch chains of the polymer matrix include activation groups, and the activation groups are available for a crosslinking reaction; and/or the molecular structure of the polymer matrix includes a crosslinked structure.

The step of synthesizing the polymer matrix is specifically: adding a free radical initiator to repeating units to synthesize the polymer matrix. The free radical initiator is used to introduce activation groups to branch chains of the repeating units. The free radical initiator may include azobisisobutyronitrile and dibenzoyl peroxide. The repeating units

may include methyl methacrylate, ethyl acrylate, glycidyl methacrylate, tetrahydrofurfuryl methacrylate, and the like.

Based on a same technical concept, an embodiment of this application further discloses a preparation method for a holographic photosensitive film. As shown in FIG. 2, the preparation method includes S201 to S203.

S201: Mix a polymer matrix, photopolymerizable monomers, and a photosensitizer, to obtain a holographic photopolymer material.

S202: Coat a protective layer with the holographic photopolymer material.

The protective layer may include but is not limited to a polyester film (polyester film, PET), a triacetyl cellulose film (triacetyl cellulose film, TAC), glass, ceramic, and a composite material including some of these materials.

S203: Convert the holographic photopolymer material into a first film layer.

A molecular structure of a polymer matrix in the first film layer includes a linear structure, branch chains of the polymer matrix include activation groups, and the activation groups are available for a crosslinking reaction; and/or the molecular structure of the polymer matrix in the first film layer includes a crosslinked structure.

Specifically, the holographic photopolymer material may be prepared into a film through a technique such as scrape coating, curtain coating, printing, spraying, or inkjet printing, to obtain the first film layer.

The foregoing S201 to S203 need to be completed in a dark place or under a safety light. A processing manner of S203 includes but is not limited to heating by an oven, and another curing manner may alternatively be used.

In a feasible implementation, a molecular structure of a polymer matrix in the holographic photopolymer material is a linear structure, and the polymer matrix in the holographic photopolymer material includes activation groups.

According to the preparation method disclosed in this implementation, in a coating process, the molecular structure of the polymer matrix in the holographic photopolymer material is the linear structure. The holographic photopolymer material has good coating performance, and the holographic photopolymer material may be uniformly coated. After coating is completed, a reaction condition is controlled, so that the branch chains of the polymer matrix undergo the crosslinking reaction, to obtain the holographic photosensitive film. A molecular structure, of the polymer matrix, that undergoes the crosslinking reaction is the crosslinked structure. Therefore, the holographic photosensitive film includes a polymer matrix of a crosslinked structure, and the polymer matrix of the crosslinked structure has a high glass transition temperature. Correspondingly, the holographic photosensitive film has good heat resistance.

In a feasible implementation, the molecular structure of the polymer matrix in the holographic photopolymer material is the linear structure. In an embodiment in which the polymer matrix in the holographic photopolymer material includes the activation groups, and in step S203, the activation groups may not undergo the crosslinking reaction, and the polymer matrix of the linear structure has small migration resistance to the photopolymerizable monomers, which facilitates migration of the photopolymerizable monomers to a coherent bright region. The holographic photosensitive film has high information recording/storage efficiency.

The polymer matrix in the holographic photosensitive film includes activation groups. After holographic recording is completed, the holographic photosensitive film is converted into a holographic optical element. The holographic optical element includes activation groups. A condition may be controlled, so that the activation groups of the holographic optical element undergo a crosslinking reaction. In this way, a polymer matrix in the holographic optical element is of a crosslinked structure, and it is ensured that the holographic optical element has good heat resistance. It can be learned that the holographic optical element obtained by using the holographic photosensitive film prepared in this implementation may have high heat resistance.

The holographic photosensitive film disclosed in this embodiment of this application is described below with reference to a specific accompanying drawing.

In a feasible implementation, for a diagram of the holographic photosensitive film, refer to FIG. 3. The holographic photosensitive film may include a first film layer and a protective layer. The first film layer includes a polymer matrix 31, photopolymerizable monomers 32, and a photosensitizer 33. The polymer matrix 31 may include main chains 311 and branch chains 312. The photopolymerizable monomers 32 and the photosensitizer 33 are dispersed in the polymer matrix 31. In this implementation, the branch chains of the polymer matrix 31 do not undergo a crosslinking reaction. That is, a molecular structure of the polymer matrix 31 is a linear structure.

In a feasible implementation, for a diagram of the holographic photosensitive film, refer to FIG. 4. The holographic photosensitive film may include a first film layer and a protective layer. The first film layer includes a polymer matrix 31, photopolymerizable monomers 32, and a photosensitizer 33. The polymer matrix 31 may include main chains 311 and branch chains 312. The photopolymerizable monomers 32 and the photosensitizer 33 are dispersed in the polymer matrix 31. In this implementation, the branch chains of the polymer matrix 31 undergo a crosslinking reaction. That is, a molecular structure of the polymer matrix 31 in the holographic photosensitive film is a crosslinked structure.

Based on a same technical concept, an embodiment of this application further discloses a preparation method for a holographic optical element. As shown in FIG. 5, the preparation method includes S501 to S504.

S501: Mix a polymer matrix, photopolymerizable monomers, and a photosensitizer to obtain a holographic photopolymer material.

S502: Coat a protective layer with the holographic photopolymer material.

S503: Convert the holographic photopolymer material into a first film layer.

For specific implementations of S501 to S503, refer to the foregoing embodiment. Details are not described herein again.

S504: Perform holographic processing, to convert the first film layer into a second film layer.

The second film layer includes a coherent bright region and a coherent dark region, and density of monomer polymers in the coherent bright region is greater than density of the monomer polymers in the coherent dark region. The monomer polymers are obtained through polymerization of the photopolymerizable monomers.

In this embodiment of this application, the holographic optical element may include a reflective holographic optical element and a transmission holographic optical element.

FIG. 6 and FIG. 7 are diagrams of principles of optical paths for holographic recording.

As shown in FIG. 6 and FIG. 7, a holographic recording system includes a laser (laser) 61, a shutter (shutter, SH), a beam expander 62, a lens 63, a reflector 64, and a beam splitter 65.

The laser 61 is configured to generate a light beam satisfying a coherence condition, and the shutter is configured to control holographic exposure time.

The beam expander 62 can change a diameter of the light beam and an angle of divergence.

The lens 63 is configured to collimate an expanded light beam.

The reflector 64 is configured to control a propagation direction of the light beam, so that the light beam propagates based on a set path.

The beam splitter 65 is configured to split the light beam into coherent light beams of a same frequency and with a constant phase difference and a same vibration direction.

In this embodiment of this application, the light beam emitted by the laser 61 is split into coherent light beams in two directions by the beam splitter 65, and the coherent light beams in the two directions separately irradiate a holographic photosensitive film, to implement holographic recording.

Refer to FIG. 6. When two coherent light beams (66 and 67) are respectively on two sides of the holographic photosensitive film 6 during holographic processing, a reflective holographic optical element is obtained.

Refer to FIG. 7. When two coherent light beams (66 and 67) are on a same side of the holographic photosensitive film 6 during holographic processing, a transmission holographic optical element is obtained.

In an implementation in which a molecular structure of a polymer matrix in the holographic photosensitive film is a linear structure, and the polymer matrix includes activation groups, S504 may include the following.

(1) Expose (irradiate) the holographic photosensitive film under a first condition, so that the coherent bright region and the coherent dark region have different concentrations of monomer polymers.

The first condition includes a condition for exciting the photosensitizer to produce active intermediates. Under the first condition, the activation groups do not undergo a crosslinking reaction.

(2) Place the exposed holographic photosensitive film under a second condition, so that the activation groups on branch chains of the polymer matrix are crosslinked and polymerized to obtain the holographic optical element.

In this implementation, the molecular structure of the polymer matrix in the holographic photosensitive film is a linear structure, and the polymer matrix of the linear structure has small migration resistance to the photopolymerizable monomers, which facilitates migration of the photopolymerizable monomers to the coherent bright region. Therefore, the holographic photosensitive film disclosed in this implementation can have high data recording/storage efficiency.

A polymer matrix in the holographic optical element obtained in this implementation is of a crosslinked structure, and the holographic optical element has good heat resistance.

The following describes, with reference to specific embodiments, performance of the holographic optical element disclosed in this embodiment of this application.

Embodiment 1:

A free radical initiator is added to repeating units for a reaction for 24 h at 60°C to 80°C, to synthesize a polymer matrix.

A 40% (wt) polymer matrix, 60% (wt) photopolymerizable monomers, a co-initiator (1.5 wt% N-methyldiethanolamine MDEA and 0.5 wt% diphenyliodonium hexafluorophosphate DPI - $PF_6$ ), and a 0.3% (wt) photosensitizer are weighed and dissolved in a solvent for later use. For a diagram of an obtained holographic photopolymer material, refer to (1) in FIG. 8. It can be learned that the holographic photopolymer material may include a polymer matrix 31, photopolymerizable monomers 32, and a photosensitizer 33. The polymer matrix 31 may include main chains 311 and branch chains 312.

The holographic photopolymer material is coated on a glass plate with a height of a scraper being 100 μm, and a film is obtained through scrape coating at a film coating speed of 200 mm/min. The obtained wet film is dried for 2 min at 40°C. Finally, a surface of the photosensitive film is coated with a holographic photosensitive film with a thickness of 50 μm. For a diagram of the holographic photosensitive film, refer to (2) in FIG. 8. It can be learned that the photopolymerizable

monomers 32 and the photosensitizer 33 are dispersed in the polymer matrix 31. In this implementation, branch chains of the polymer matrix do not undergo a crosslinking reaction. That is, a molecular structure of the polymer matrix 31 is a linear structure.

Exposure (holographic processing) is performed on the holographic photosensitive film based on the optical path for holographic recording in FIG. 6. A wavelength of a light beam is 660 nm, and exposure energy is 30 mJ / $cm^2$. Then, the holographic photosensitive film is irradiated under a high-pressure mercury lamp for 5 min, and a holographic photosensitive film with holographic recording may be obtained. For a diagram of the holographic photosensitive film with holographic recording, refer to (3) in FIG. 8. The holographic photosensitive film with holographic recording may include monomer polymers 34 and the polymer matrix 31. The molecular structure of the polymer matrix 31 is the linear structure, and the polymer matrix 31 includes the branch chains 312. Density of the monomer polymers 34 in a coherent bright region A is greater than density of the monomer polymers 34 in a coherent dark region B, and the holographic photosensitive film with holographic recording is obtained.

A reaction condition is adjusted, so that the branch chains 312 in the holographic photosensitive film with holographic recording undergo the crosslinking reaction. For an obtained holographic optical element, refer to (4) in FIG. 8.

Holographic optical elements in Embodiment 2 to Embodiment 10 have a similar structure as the holographic optical element in Embodiment 1, and a difference lies in that components of holographic photopolymer materials used in Embodiment 2 to Embodiment 10 and an addition amount of each component are different from those of the holographic photopolymer material used in Embodiment 1. For details, refer to data in Table 1. Photopolymerizable monomer content may be approximately understood as content of photopolymerizable monomers, or an addition amount of photopolymerizable monomers.

Test items of the holographic optical elements disclosed in Embodiment 1 to Embodiment 10 include transmittance, diffraction efficiency, and a decrease degree in the transmittance at 400 nm after heating for 6 h at 100°C. For test results, refer to corresponding data in Table 1.

A test process of each test item is as follows:

(1) The transmittance T of the holographic optical element at the 400 nm wavelength is measured with an ultraviolet-visible spectrophotometer.

(2) The diffraction efficiency (η) of the holographic optical element is measured with the ultraviolet-visible spectrophotometer.

Specifically, minimum transmittance (TB) of a reflection peak and transmittance (TA) of a baseline are first determined, where the transmittance of the baseline is a vertical coordinate value of an intersection point between a peak value of the minimum transmittance and the baseline, and then, the diffraction efficiency (η) is calculated according to the following formula:

$$\eta=\frac{TA-TB}{TA}*100\% .$$

(3) The decrease degree in the transmittance of the holographic optical element at 400 nm after heating for 6 h at 100°C is measured with the ultraviolet-visible spectrophotometer.

Specifically, transmittance (TC) of the holographic optical element before heating is measured, transmittance (TD) of the holographic optical element after heating for 6 h at 100°C is measured, and then the decrease degree (0) of the transmittance is calculated according to the following formula:

$$\theta=\frac{TC-TD}{TC}*100\% .$$

Table 1

| | Components of a holographic photopolymer material | | | | | Performance of a holographic optical element | | |
|---|---|---|---|---|---|---|---|---|
| | Epoxy content (mol%) of the holographic photopolymer material | Polymer matrix content (wt%) | Photopolymerizable monomer content (wt%) | Co-initiator and co-initiator content | Photosensitizer and photosensitizer content | Diffraction efficiency (%) | Transmittance at 400 nm (%) | Decrease degree of the transmittance at 400 nm after heating for 6 h at 100°C (%) |
| Embodiment 1 | 17 | 40 | 60 | 1.5 wt% MDEA, 0.5 wt% DPI-$FP_6$ | 0.3 wt% KCD | 85 | 82 | 2.4 |
| Embodiment 2 | 50 | 40 | 60 | 1.5 wt% MDEA, 0.5 wt% DPI - $FP_6$ | 0.3 wt% KCD | 62 | 64 | 0.8 |
| Embodiment 3 | 40 | 40 | 60 | 1.5 wt% MDEA, 0.5 wt% DPI - $FP_6$ | 0.3 wt% KCD | 63 | 69 | 1.6 |
| Embodiment 4 | 30 | 40 | 60 | 1.5 wt% MDEA, 0.5 wt% DPI - $FP_6$ | 0.3 wt% KCD | 70 | 73 | 2.1 |
| Embodiment 5 | 20 | 40 | 60 | 1.5 wt% MDEA, 0.5 wt% DPI - $FP_6$ | 0.3 wt% KCD | 77 | 79 | 4.1 |
| Embodiment 6 | 20 | 40 | 60 | 1.5 wt% MDEA, 0.5 wt% DPI-Cl | 0.3 wt% KCD | 88 | 81 | 31.3 |
| Embodiment 7 | 20 | 40 | 60 | 1.5 wt% MDEA, 0.5 wt% DPI - $FP_6$ | 0.3 wt% RB | 65 | 75 | 3.9 |

(continued)

| | Components of a holographic photopolymer material | | | | | Performance of a holographic optical element | | |
|---|---|---|---|---|---|---|---|---|
| | Epoxy content (mol%) of the holographic photopolymer material | Polymer matrix content (wt%) | Photopolymerizable monomer content (wt%) | Co-initiator and co-initiator content | Photosensitizer and photosensitizer content | Diffraction efficiency (%) | Transmittance at 400 nm (%) | Decrease degree of the transmittance at 400 nm after heating for 6 h at 100°C (%) |
| Embodiment 8 | 20 | 40 | 60 | 0.5 wt% DPI - $FP_6$ | 0.3 wt% RB | 32 | 65 | 10.3 |
| Embodiment 9 | 20 | 40 | 60 | 1.5 wt% MDEA, 0.5 wt% DPI - $FP_6$ | 0.3 wt% NMB | 20 | 59 | 8.9 |
| Embodiment 10 | 20 | 40 | 60 | 1.5 wt% MDEA, 0.5 wt% DPI - $FP_6$ | 0.6 wt% NMB | 66 | 66 | 7.6 |

The components of the holographic photopolymer materials in Embodiment 1 to Embodiment 10, and the performance of the holographic optical elements in Embodiment 1 to Embodiment 10.

For a full name of each component in Table 1, refer to Table 2.

Table 2

| Chinese name | Corresponding abbreviation in Table 1 |
|---|---|
| 3,3'-carbonylbis(7-diethylaminocoumarin) | KCD |
| *N*-methyldiethanolamine | MDEA |
| Diphenyliodonium hexafluorophosphate | DPI-$PF_6$ |
| Dichloromethane | DCM |
| Tetrachlorotetraiodofluorescein disodium | RB |
| New methylene blue | NMB |

It can be learned from the decrease degrees of the transmittance that correspond to Embodiment 1 to Embodiment 10 in Table 1 that, after the holographic optical elements disclosed in embodiments of this application are heated at 100°C for 6 h, the decrease degrees of the transmittance of the holographic optical elements are all less than 35%. Except a holographic optical element disclosed in Embodiment 6, decrease degrees of transmittance of holographic optical elements disclosed in other embodiments are around 10% after the holographic optical elements are heated at 100°C for 6 h. It can be learned that the holographic optical elements disclosed in embodiments of this application have good heat resistance.

It can be learned from the transmittance corresponding to Embodiment 1 to Embodiment 10 in Table 1 that the transmittance of the holographic optical elements disclosed in embodiments of this application is all greater than 50%, and the holographic optical elements have large transmittance.

It can be learned from the diffraction efficiency corresponding to Embodiment 1 to Embodiment 10 in Table 1 that diffraction efficiency of holographic optical elements disclosed in Embodiment 1 to Embodiment 7 is greater than 50%, and the holographic optical elements disclosed in Embodiment 1 to Embodiment 7 have high diffraction efficiency.

Based on a same technical concept, an embodiment of this application further discloses a display device, including the holographic optical element or the holographic photosensitive film disclosed in embodiments of this application. The display device is, for example, a head-up display (head-up display, HUD) device.

Based on a same technical concept, an embodiment of this application further discloses a storage device, including the holographic optical element or the holographic photosensitive film disclosed in embodiments of this application.

Based on a same technical concept, an embodiment of this application further discloses an anti-counterfeit identifier, including the holographic optical element or the holographic photosensitive film disclosed in embodiments of this application.

A person skilled in the art can easily figure out another implementation solution of the present disclosure after considering the specification and practicing the present invention that is disclosed herein. This application is intended to cover any variations, functions, or adaptive changes of the present disclosure. These variations, functions, or adaptive changes comply with general principles of the present disclosure, and include common knowledge or a commonly used technical means in the technical field that is not disclosed in the present disclosure. The specification and embodiments are merely considered as examples, and the actual scope and the spirit of the present disclosure are pointed out by the following claims.

It should be understood that the present disclosure is not limited to the accurate structures that are described in the foregoing and that are shown in the accompanying drawings, and modifications and changes may be made without departing from the scope of the present disclosure. The scope of the present disclosure is limited only by the appended claims.

## Claims

**1.** A holographic photopolymer material, comprising:

a polymer matrix;
photopolymerizable monomers, wherein an index of refraction of the photopolymerizable monomer is greater

than an index of refraction of the polymer matrix; and
a photosensitizer, wherein
a molecular structure of the polymer matrix comprises a linear structure, branch chains of the polymer matrix comprise activation groups, and the activation groups are available for a crosslinking reaction;
and/or
the molecular structure of the polymer matrix comprises a crosslinked structure.

**2.** The holographic photopolymer material according to claim 1, wherein the polymer matrix comprises at least one of polymethacrylate, polymethacrylamide, polyacrylate, polyacrylamide, polyvinyl ether, polyvinyl ester, and polysiloxane.

**3.** The holographic photopolymer material according to claim 1 or 2, wherein the polymer matrix comprises a copolymer comprising at least two of the following substances: methacrylate, methacrylamide, acrylate, acrylamide, vinyl ether, vinyl ester, and siloxane.

**4.** The holographic photopolymer material according to any one of claims 1 to 3, wherein the activation group comprises at least one of an epoxy group, vinyl ether, and an N-vinyl group.

**5.** The holographic photopolymer material according to any one of claims 1 to 4, wherein a structural formula of the photopolymerizable monomer comprises:

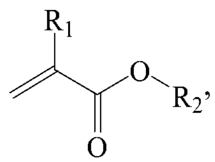

wherein

$R_1$ comprises H or $CH_3$; and
$R_2$ comprises at least one of 1,3-bis(thieno-2-ylthio)propan-2-yl, 1,3-bis((4-(phenylthio)phenyl)thio)propan-2-yl, and 1,3-bis((4-bromophenyl)thio)propan-2-yl.

**6.** The holographic photopolymer material according to any one of claims 1 to 5, further comprising a co-initiator, wherein the co-initiator comprises at least one of tetrabutylammonium tetrahexylborate, tetrabutylammonium hexyltrisphenylborate, tetrabutylammonium tris(3-fluorophenyl)hexylborate, and tetrabutylammonium tris(3-chloro-4-methylphenyl)hexylborate.

**7.** The holographic photopolymer material according to any one of claims 1 to 6, wherein an infrared spectrum of the holographic photopolymer material comprises a first characteristic absorption peak and a second characteristic absorption peak; and
a wavenumber of the first characteristic absorption peak ranges from 877 $cm^{-1}$ to 831 $cm^{-1}$, and a wavenumber of the second characteristic absorption peak ranges from 829 $cm^{-1}$ to 787 $cm^{-1}$.

**8.** The holographic photopolymer material according to claim 7, wherein a ratio of a peak area of the first characteristic absorption peak to a peak area of the second characteristic absorption peak ranges from 0.4 to 8.8.

**9.** The holographic photopolymer material according to any one of claims 1 to 8, wherein a nuclear magnetic resonance hydrogen spectrum of the holographic photopolymer material comprises a third characteristic absorption peak and a fourth characteristic absorption peak, a chemical shift of the third characteristic absorption peak ranges from 3.2 ppm to 3.22 ppm, and a chemical shift of the fourth characteristic absorption peak ranges from 3.5 ppm to 3.7 ppm.

**10.** The holographic photopolymer material according to any one of claims 1 to 9, wherein a glass transition temperature of the polymer matrix is greater than or equal to 50°C.

**11.** A holographic photosensitive film, comprising a protective layer and a first film layer covering the protective layer, wherein the first film layer is made from the holographic photopolymer material according to any one of claims 1 to 10.

**12.** A holographic optical element, comprising a protective layer and a second film layer covering the protective layer, wherein materials used for the second film layer comprise a polymer matrix and monomer polymers, and a molecular structure of the polymer matrix comprises a crosslinked structure; and
the second film layer comprises a coherent bright region and a coherent dark region, and density of the monomer polymers in the coherent bright region is greater than density of the monomer polymers in the coherent dark region.

**13.** The holographic optical element according to claim 12, wherein an infrared spectrum of the second film layer comprises a fifth characteristic absorption peak and a sixth characteristic absorption peak, a wavenumber of the fifth characteristic absorption peak ranges from 1768 $cm^{-1}$ to 1692 $cm^{-1}$, and a wavenumber of the sixth characteristic absorption peak ranges from 1093 $cm^{-1}$ to 1023 $cm^{-1}$.

**14.** The holographic optical element according to claim 13, wherein a ratio of a peak area of the fifth characteristic absorption peak to a peak area of the sixth characteristic absorption peak ranges from 1.0 to 4.4.

**15.** A preparation method for a holographic photopolymer material, comprising:

synthesizing a polymer matrix, wherein a molecular structure of the polymer matrix comprises a linear structure, branch chains of the polymer matrix comprise activation groups, and the activation groups are available for a crosslinking reaction; and
mixing the polymer matrix, photopolymerizable monomers, and a photosensitizer to obtain the holographic photopolymer material according to any one of claims 1 to 10.

**16.** A preparation method for a holographic photosensitive film, comprising:

coating a protective layer with the holographic photopolymer material obtained according to claim 15; and
converting the holographic photopolymer material into a first film layer, wherein a molecular structure of the polymer matrix in the first film layer comprises a linear structure, branch chains of the polymer matrix comprise activation groups, and the activation groups are available for a crosslinking reaction;
and/or
the molecular structure of the polymer matrix in the first film layer comprises a crosslinked structure.

**17.** A preparation method for a holographic optical element, comprising:
performing holographic processing on the holographic photosensitive film obtained according to claim 16, to convert the first film layer into a second film layer, wherein the second film layer comprises a coherent bright region and a coherent dark region, density of monomer polymers in the coherent bright region is greater than density of the monomer polymers in the coherent dark region, and the monomer polymers are obtained through polymerization of the photopolymerizable monomers.

**18.** A display device, comprising a display and an optical element disposed on the display, wherein
the optical element comprises the holographic photosensitive film according to claim 11, or the holographic optical element according to any one of claims 12 to 14.

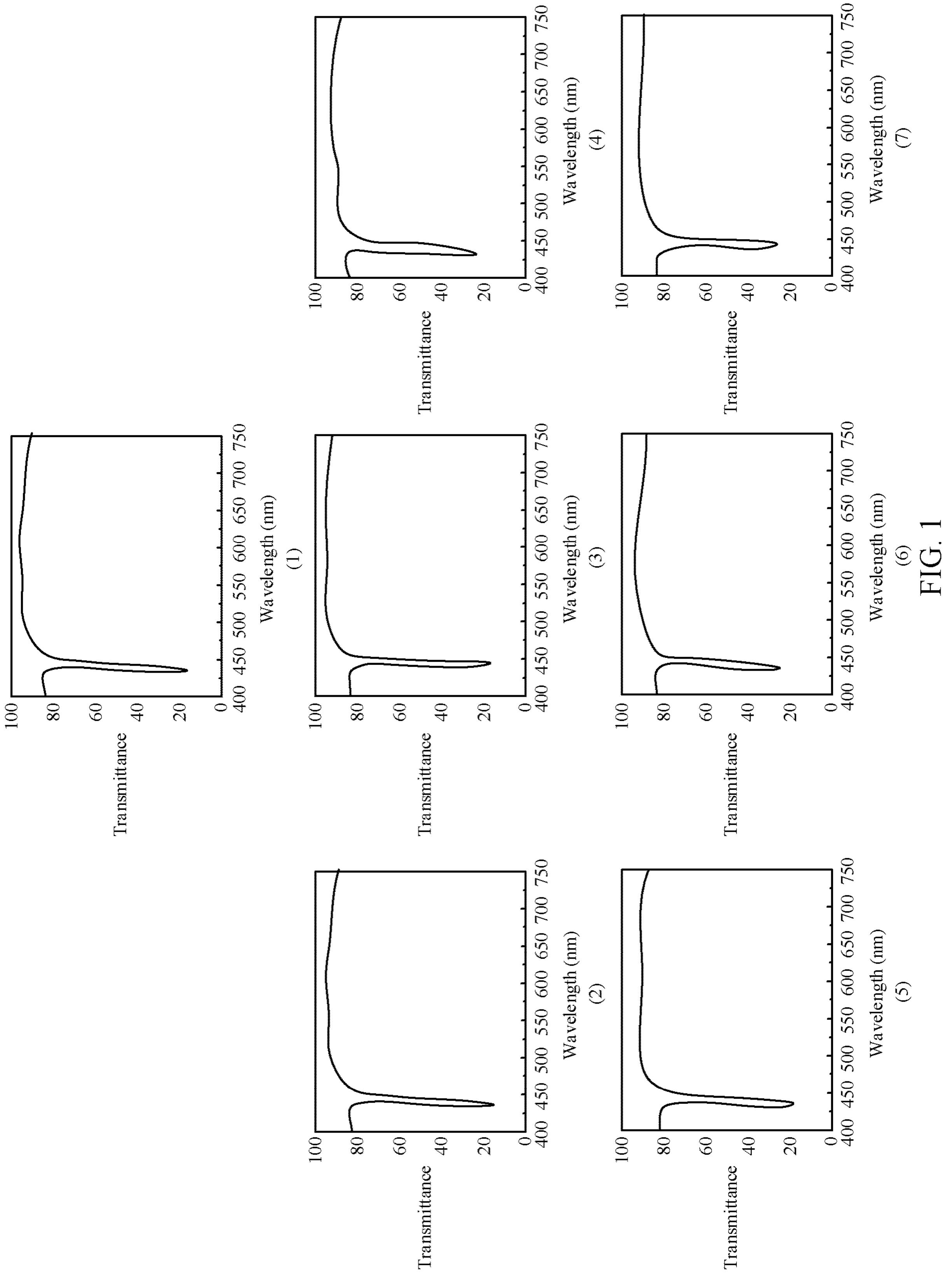


FIG. 1

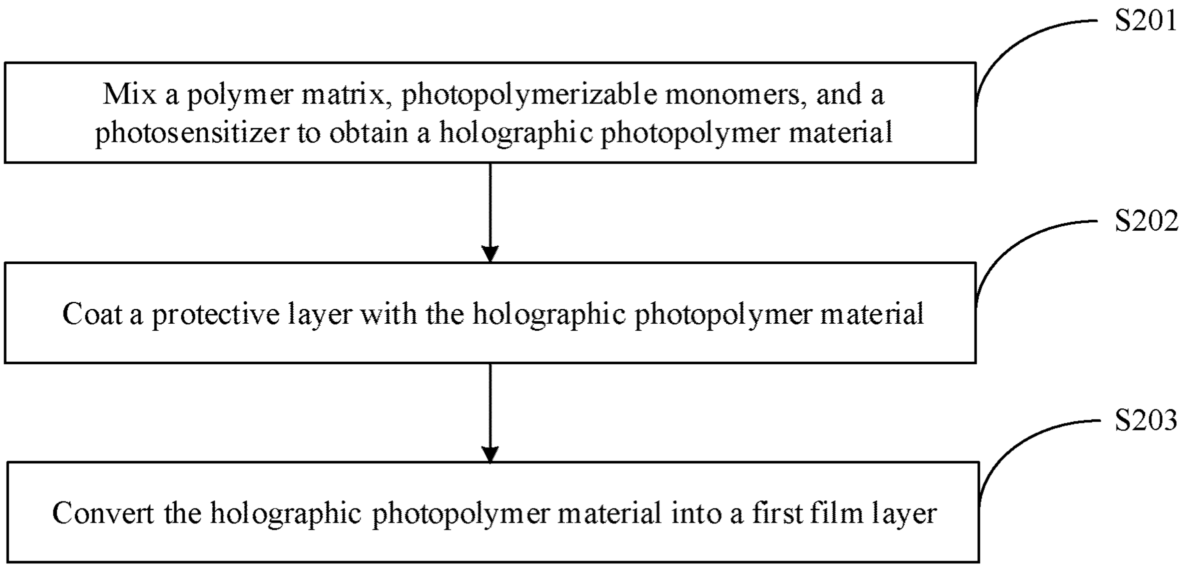
S201
Mix a polymer matrix, photopolymerizable monomers, and a photosensitizer to obtain a holographic photopolymer material
S202
Coat a protective layer with the holographic photopolymer material
S203
Convert the holographic photopolymer material into a first film layer

FIG. 2

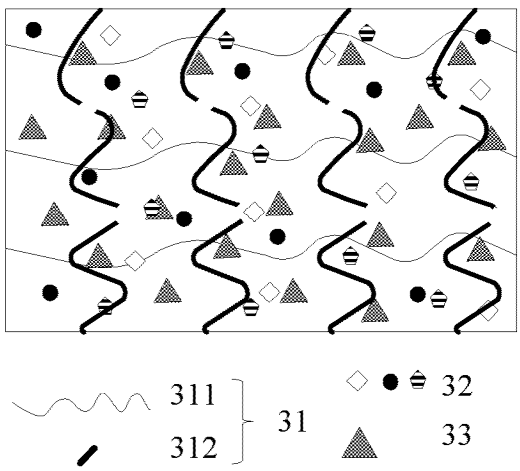
311
312
31
32
33

FIG. 3

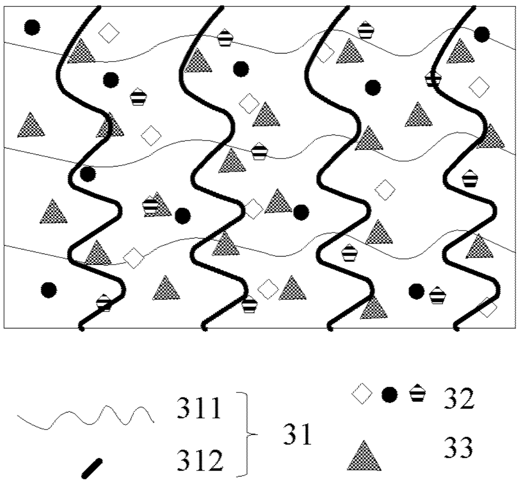
311
312
31
32
33

FIG. 4

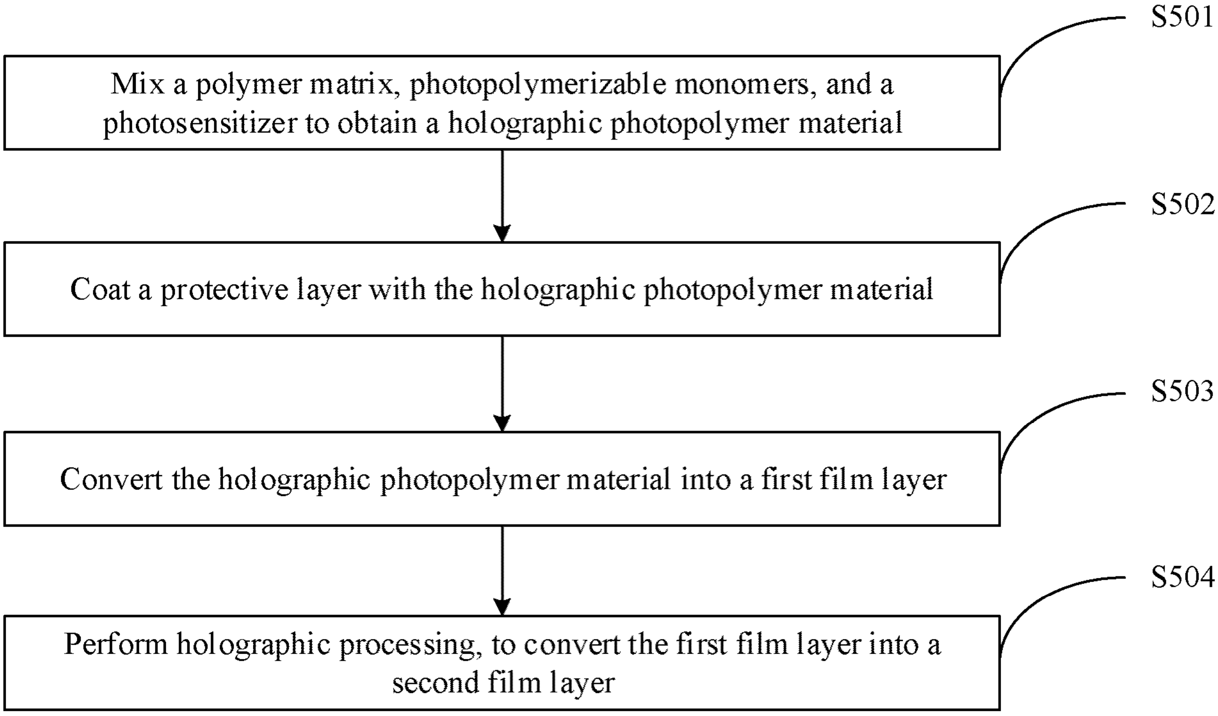
S501
Mix a polymer matrix, photopolymerizable monomers, and a photosensitizer to obtain a holographic photopolymer material
S502
Coat a protective layer with the holographic photopolymer material
S503
Convert the holographic photopolymer material into a first film layer
S504
Perform holographic processing, to convert the first film layer into a second film layer

FIG. 5

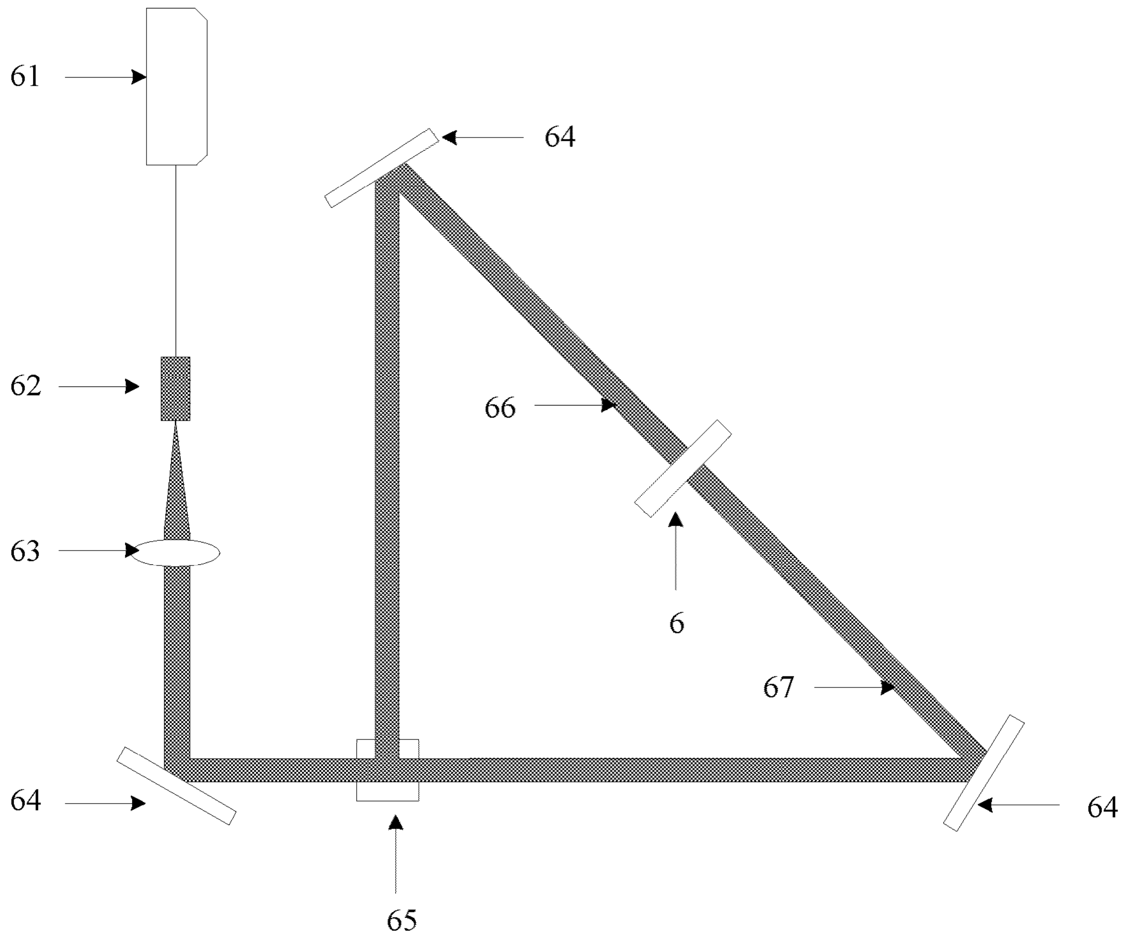


FIG. 6

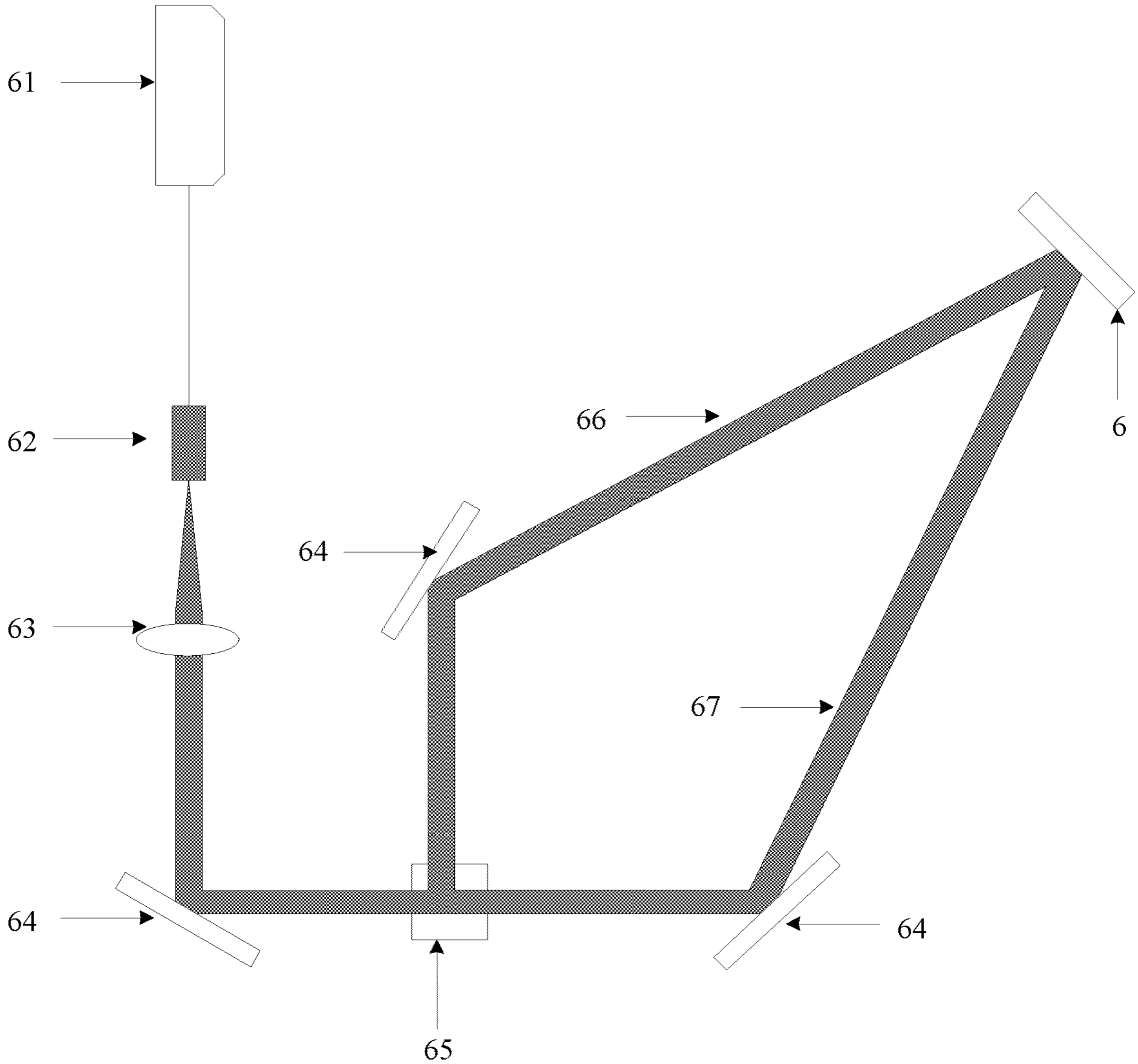


FIG. 7

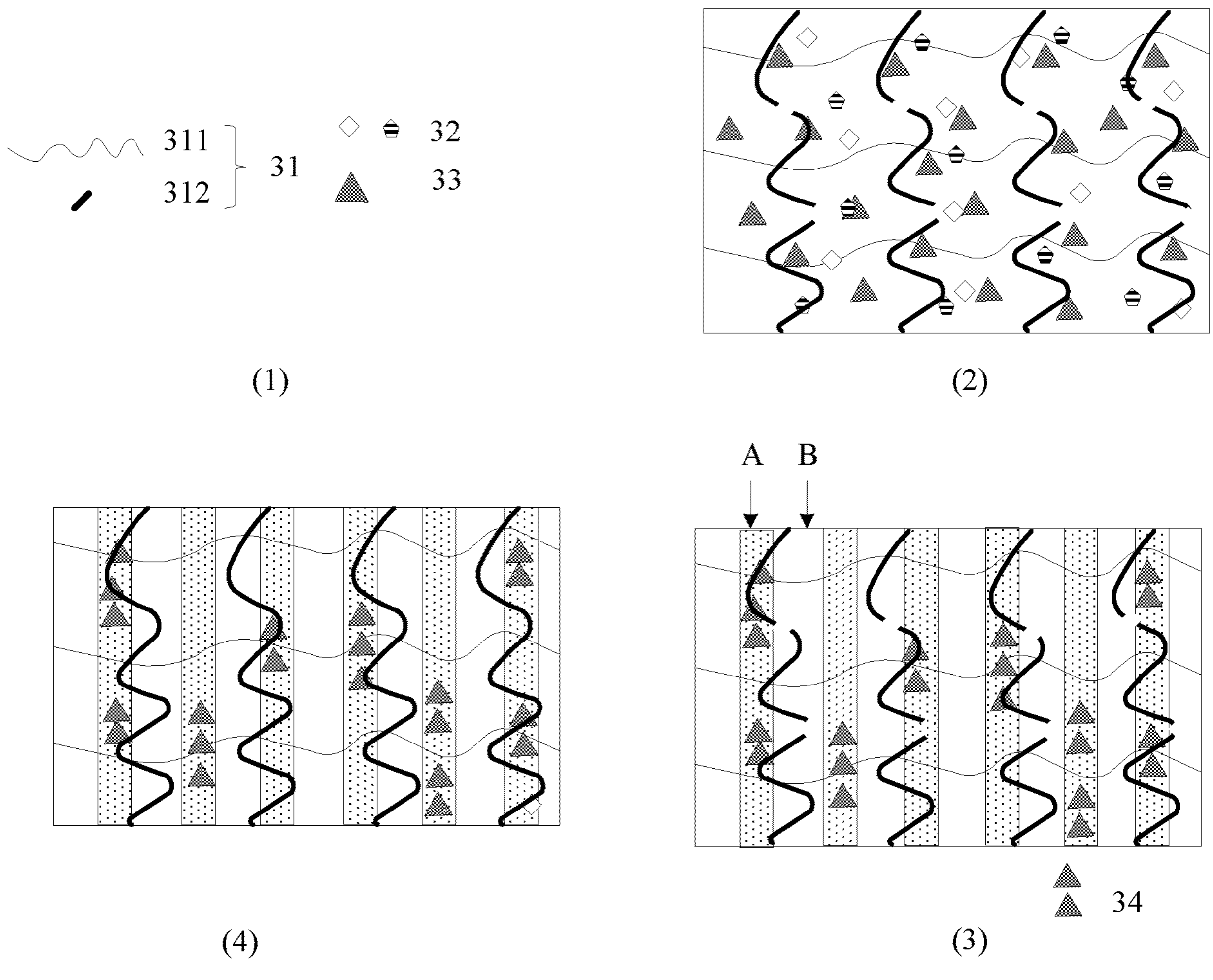


FIG. 8

**INTERNATIONAL SEARCH REPORT**

International application No.
**PCT/CN2024/076458**

**A. CLASSIFICATION OF SUBJECT MATTER**

G03F7/004(2006.01)i

According to International Patent Classification (IPC) or to both national classification and IPC

**B. FIELDS SEARCHED**

Minimum documentation searched (classification system followed by classification symbols)

IPC:G03F7,G11B7,G03H1

Documentation searched other than minimum documentation to the extent that such documents are included in the fields searched

Electronic data base consulted during the international search (name of data base and, where practicable, search terms used)

ISI, CJFD, CNTXT, DWPI, ENTXT, ENTXTC, WPABS, WPABSC: 单体, 基质, 聚合, 全息, 线性, 支链, 折射, holographic, polymer matrix, linear, branched, crosslink, refractive index

**C. DOCUMENTS CONSIDERED TO BE RELEVANT**

| Category* | Citation of document, with indication, where appropriate, of the relevant passages | Relevant to claim No. |
|---|---|---|
| X | US 2011117477 A1 (SMART HOLOGRAMS LTD.) 19 May 2011 (2011-05-19) claims 1, 4-5, 15, 19-23, 29, 39, 51-55, 92 and 95-97, and description, paragraphs 146-147 and 192 | 1-4, 6-18 |
| A | CN 101713923 A (BAYER MATERIALSCIENCE AG) 26 May 2010 (2010-05-26) entire document | 1-18 |
| A | CN 102037346 A (SMART HOLOGRAMS LTD.) 27 April 2011 (2011-04-27) entire document | 1-18 |
| A | CN 102971677 A (DAICEL CORP.) 13 March 2013 (2013-03-13) entire document | 1-18 |
| A | JP 2012047787 A (DAICEL CORP.) 08 March 2012 (2012-03-08) entire document | 1-18 |
| A | US 2003044691 A1 (INPHASE TECH INC.) 06 March 2003 (2003-03-06) entire document | 1-18 |
| A | US 2006199081 A1 (GENERAL ELECTRIC COMPANY) 07 September 2006 (2006-09-07) entire document | 1-18 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 May 2024** | **16 May 2024** |

| Name and mailing address of the ISA/CN | Authorized officer |
|---|---|
| **China National Intellectual Property Administration (ISA/CN)<br>China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**

International application No.
**PCT/CN2024/076458**

**C. DOCUMENTS CONSIDERED TO BE RELEVANT**

| Category* | Citation of document, with indication, where appropriate, of the relevant passages | Relevant to claim No. |
|---|---|---|
| A | US 2010128589 A1 (KYOEISHA CHEMICAL CO., LTD. et al.) 27 May 2010 (2010-05-27) entire document | 1-18 |
| A | US 2020192218 A1 (LG CHEMICAL LTD.) 18 June 2020 (2020-06-18) entire document | 1-18 |
| A | US 2020355996 A1 (LG CHEMICAL LTD.) 12 November 2020 (2020-11-12) entire document | 1-18 |
| A | WO 2012124317 A1 (NIPPON STEEL CHEMICAL CO. et al.) 20 September 2012 (2012-09-20) entire document | 1-18 |

Form PCT/ISA/210 (second sheet) (July 2022)

**INTERNATIONAL SEARCH REPORT**

International application No.
**PCT/CN2024/076458**

**Box No. III Observations where unity of invention is lacking (Continuation of item 3 of first sheet)**

This International Searching Authority found multiple inventions in this international application, as follows:

Claims 1-10 relate to a holographic photopolymerization material; claim 11 relates to a holographic photosensitive film using the holographic photopolymerization material of claims 1-10; claims 12-14 relate to a holographic optical element; claim 15 relates to a method for preparing the holographic photopolymerization material of claims 1-10; claim 16 relates to a method for preparing a holographic photosensitive film using the holographic photopolymerization material of claim 15; claim 17 relates to a method for preparing a holographic optical element, wherein the holographic photosensitive film of claim 16 is applied; and claim 18 relates to a display device, which comprises the holographic photosensitive film of claim 11 or the holographic optical element of claims 12-14. In addition to independent claim 12, other independent claims all directly or indirectly refer to claims 1-10. Moreover, the only same or corresponding technical features between independent claim 12 and independent claims 1 and 15-17 are "holographic" and "polymer matrix", and the only same or corresponding technical features between independent claim 12 and independent claim 11 are "holographic", "protective layer" and "polymer matrix". However, a holographic photopolymerization material and a holographic optical element containing a polymer matrix and a protective layer are common technical means in the pertinent art. Therefore, independent claims 1, 11 and 15-17 and independent claim 12 would not have a same or corresponding special technical feature that defines a contribution which the inventions make over the prior art, do not have a technical relationship therebetween, do not fall within a single general inventive concept, and therefore do not comply with the requirement of unity of invention and do not comply with PCT Rule 13.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

**INTERNATIONAL SEARCH REPORT**
**Information on patent family members**

International application No.
**PCT/CN2024/076458**

| Patent document cited in search report | | | Publication date (day/month/year) | Patent family member(s) | | | Publication date (day/month/year) |
|---|---|---|---|---|---|---|---|
| US | 2011117477 | A1 | 19 May 2011 | None | | | |
| CN | 101713923 | A | 26 May 2010 | JP | 2010111858 | A | 20 May 2010 |
| | | | | JP | 5544136 | B2 | 09 July 2014 |
| | | | | KR | 20100037557 | A | 09 April 2010 |
| | | | | KR | 101680894 | B1 | 29 November 2016 |
| | | | | IL | 200996 | A0 | 30 June 2010 |
| | | | | RU | 2009136169 | A | 10 April 2011 |
| | | | | RU | 2515991 | C2 | 20 May 2014 |
| | | | | RU | 2515991 | C9 | 20 February 2015 |
| | | | | BRPI | 0903847 | A2 | 20 July 2010 |
| | | | | BRPI | 0903847 | B1 | 30 April 2019 |
| | | | | SG | 160313 | A1 | 29 April 2010 |
| | | | | ATE | 517139 | T1 | 15 August 2011 |
| | | | | EP | 2172504 | A1 | 07 April 2010 |
| | | | | EP | 2172504 | B1 | 20 July 2011 |
| | | | | TW | 201033241 | A | 16 September 2010 |
| | | | | TWI | 477525 | B | 21 March 2015 |
| | | | | US | 2010087564 | A1 | 08 April 2010 |
| | | | | US | 9505873 | B2 | 29 November 2016 |
| | | | | CA | 2680974 | A1 | 01 April 2010 |
| CN | 102037346 | A | 27 April 2011 | JP | 2011523452 | A | 11 August 2011 |
| | | | | EP | 2277027 | A1 | 26 January 2011 |
| | | | | US | 2011117477 | A1 | 19 May 2011 |
| | | | | WO | 2009127824 | A1 | 22 October 2009 |
| | | | | TW | 201001102 | A | 01 January 2010 |
| CN | 102971677 | A | 13 March 2013 | JP | 2012047787 | A | 08 March 2012 |
| | | | | WO | 2012026298 | A1 | 01 March 2012 |
| | | | | TW | 201219975 | A | 16 May 2012 |
| | | | | KR | 20130138217 | A | 18 December 2013 |
| JP | 2012047787 | A | 08 March 2012 | None | | | |
| US | 2003044691 | A1 | 06 March 2003 | JP | 2009025838 | A | 05 February 2009 |
| | | | | JP | 5295712 | B2 | 18 September 2013 |
| | | | | EP | 1414878 | A1 | 06 May 2004 |
| | | | | EP | 1414878 | B1 | 28 June 2006 |
| | | | | WO | 03014178 | A1 | 20 February 2003 |
| | | | | DE | 60212854 | D1 | 10 August 2006 |
| | | | | DE | 60212854 | T2 | 06 September 2007 |
| | | | | JP | 2004537620 | A | 16 December 2004 |
| | | | | ATE | 331744 | T1 | 15 July 2006 |
| | | | | KR | 20040058172 | A | 03 July 2004 |
| | | | | KR | 100920260 | B1 | 05 October 2009 |
| | | | | US | 6743552 | B2 | 01 June 2004 |
| US | 2006199081 | A1 | 07 September 2006 | TW | 200641567 | A | 01 December 2006 |
| | | | | WO | 2006096437 | A1 | 14 September 2006 |
| US | 2010128589 | A1 | 27 May 2010 | JPWO | 2009014133 | A1 | 07 October 2010 |
| | | | | JP | 4792526 | B2 | 12 October 2011 |
| | | | | KR | 20100057603 | A | 31 May 2010 |
| | | | | KR | 101499903 | B1 | 06 March 2015 |
| | | | | TW | 200922962 | A | 01 June 2009 |

Form PCT/ISA/210 (patent family annex) (July 2022)

**INTERNATIONAL SEARCH REPORT**
**Information on patent family members**

International application No.
**PCT/CN2024/076458**

| Patent document cited in search report | | | Publication date (day/month/year) | Patent family member(s) | | | Publication date (day/month/year) |
|---|---|---|---|---|---|---|---|
| | | | | TWI | 429674 | B | 11 March 2014 |
| | | | | EP | 2177956 | A1 | 21 April 2010 |
| | | | | EP | 2177956 | A4 | 12 October 2011 |
| | | | | EP | 2177956 | B1 | 16 October 2013 |
| | | | | US | 8383295 | B2 | 26 February 2013 |
| | | | | WO | 2009014133 | A1 | 29 January 2009 |
| US | 2020192218 | A1 | 18 June 2020 | US | 11126082 | B2 | 21 September 2021 |
| | | | | JP | 2020516934 | A | 11 June 2020 |
| | | | | JP | 6991242 | B2 | 14 January 2022 |
| | | | | KR | 20190069316 | A | 19 June 2019 |
| | | | | KR | 102166848 | B1 | 16 October 2020 |
| US | 2020355996 | A1 | 12 November 2020 | JP | 2021501906 | A | 21 January 2021 |
| | | | | JP | 7009018 | B2 | 25 January 2022 |
| | | | | KR | 20200031429 | A | 24 March 2020 |
| | | | | KR | 102338107 | B1 | 09 December 2021 |
| | | | | US | 11307494 | B2 | 19 April 2022 |
| | | | | WO | 2020055096 | A1 | 19 March 2020 |
| | | | | EP | 3683795 | A1 | 22 July 2020 |
| | | | | EP | 3683795 | A4 | 20 January 2021 |
| | | | | EP | 3683795 | B1 | 21 June 2023 |
| WO | 2012124317 | A1 | 20 September 2012 | US | 2013321783 | A1 | 05 December 2013 |
| | | | | JP | 2012194335 | A | 11 October 2012 |
| | | | | JP | 5747345 | B2 | 15 July 2015 |
| | | | | TW | 201250678 | A | 16 December 2012 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202310368492